(19) Europäisches Patentamt
European Patent Office
Office européen des brevets

(11) EP 4 703 428 A1

(12) # EUROPEAN PATENT APPLICATION
published in accordance with Art. 153(4) EPC

(43) Date of publication:
**04.03.2026 Bulletin 2026/10**

(21) Application number: **24796629.4**

(22) Date of filing: **15.03.2024**

(51) International Patent Classification (IPC):
***C08L 63/00*** *(2006.01)* ***C08G 59/42*** *(2006.01)*
***C08K 3/08*** *(2006.01)* ***C08K 5/092*** *(2006.01)*
***C09J 9/02*** *(2006.01)* ***C09J 11/04*** *(2006.01)*
***C09J 11/06*** *(2006.01)* ***C09J 163/00*** *(2006.01)*
***H01B 1/22*** *(2006.01)* ***H05K 3/12*** *(2006.01)*

(52) Cooperative Patent Classification (CPC):
**C08G 59/42; C08K 3/08; C08K 5/092; C08L 63/00; C09J 9/02; C09J 11/04; C09J 11/06; C09J 163/00; H01B 1/22; H05K 3/12**

(86) International application number:
**PCT/JP2024/010273**

(87) International publication number:
**WO 2024/224871 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.04.2023 JP 2023071531**
**08.02.2024 JP 2024017921**

(71) Applicant: **Sakata INX Corporation**
**Osaka-shi, Osaka 541-0047 (JP)**

(72) Inventors:
- **FUKUSHIMA, Ko**
**Osaka-shi, Osaka 541-0047 (JP)**
- **SAKAI, Syuta**
**Osaka-shi, Osaka 541-0047 (JP)**

(74) Representative: **Hasegawa, Kan**
**Patentanwaltskanzlei Hasegawa**
**Untere Hauptstraße 56**
**85354 Freising (DE)**

(54) **CONDUCTIVE RESIN COMPOSITION**

(57) It is an object to provide a conductive resin composition containing a tin powder, where the conductive resin composition has excellent room temperature (25°C) storage stability and refrigeration (4°C) storage stability, can form a conductive film having a low volume resistivity to exhibit an excellent conductivity, and is advantageous in cost. The solution is to provide a conductive resin composition that contains a tin powder (a), an epoxy resin (b), and a dicarboxylic acid compound (c), wherein the epoxy resin (b) includes an epoxy resin that has an epoxy equivalent of 400 g/eq or more and is in a solid or semisolid state at 25°C, and the dicarboxylic acid compound (c) includes a dicarboxylic acid compound having 4 or more and 9 or less carbon atoms.

EP 4 703 428 A1

## Description

### Technical Field

The present invention relates to a conductive resin composition. In addition, the present invention relates to a conductive film, a conductive material that is used when a circuit or the like is formed on a substrate by printing using a screen printing method and the like, a conductive adhesive, and a circuit connection material that is used in conductive connection of an electronic component to a circuit board or the like.

### Background Art

Conductive resin compositions with a wide variety of compositions are known and are used as a conductive paste, a conductive film, a conductive material, a conductive coating material, a circuit connection material, a conductive adhesive, or the like in various purposes such as formation of an electronic circuit and adhesion of an electronic component.
For example, in order to form a conductive structure such as a conductive circuit and an electrode, a conductive resin composition that can form a conductive film having a low volume resistivity and an excellent conductivity is required.
For example, a conductive material that can be applied to various printing methods and is useful for manufacturing a flexible plastic substrate having a conductive structure such as interconnection, a trace, and an electrode is required.
For example, electronic devices such as a computer and a mobile phone require a circuit connection material for mounting various electronic components, such as an LED element, a semiconductor element, and a condenser, on a single circuit board at a high density for high integration are required.
As conductive resin compositions, conductive resin compositions (conductive pastes) including various resins and various conductive particles are known. However, known conductive resin compositions do not have a sufficiently low volume resistivity and need to use a silver particle as a conductive particle when applied to a purpose that requires an excellent conductivity (a low volume resistivity) and have a problem in cost. In addition, when a large amount of conductive particles are contained for reducing the volume resistivity of a conductive film formed from a conductive resin composition, the adhesion (bonding strength) of the film to various substrates decreases and is not satisfactory.
Patent literature 1 discloses a conductive paste composition containing a conductive powder that is a silver-based powder at least including silver, a resin component that is at least one of a thermosetting resin and a thermoplastic resin, and further an ester-based compound or its salt having specific molecular weight and structure or an ether/amine-based compound.
Patent literature 2 discloses a conductive resin composition including a tin powder, a resin, and an organic acid compound. This conductive resin composition has a low volume resistivity when formed into a conductive film, shows a good conductivity, and can be used as a substitute of a silver paste, and is considered to be a conductive resin composition that is useful as a conductive material, a conductive adhesive, a circuit connection material, or the like.
Patent literature 3 discloses a conductive adhesive containing 85 wt% or more and 92 wt% or less of conductive metal powder and a binder as the remainder. The binder includes an epoxy resin, an acid anhydride-based curing agent, an organic acid, and a rubber particle having a particle size of 100 nm or more and 300 nm or less, and the proportion of the rubber particle is 8 wt% or more and 25 wt% or less based on 100 wt% of the binder. This conductive adhesive can bond a metal to a metal at a temperature lower than the melting point of the conductive metal powder and is considered to be a conductive adhesive suppressed in bleeding.
Patent literature 4 discloses a conductive adhesive composed of an organic resin and a conductive filler. The conductive adhesive includes a main conductive filler composed of from 20 to less than 100 wt% of tin and/or tin alloy, a powder of silver and/or silver alloy or gold and/or gold alloy, or another conductive filler composed of a powder filler plated with such a metal, a binder, and an organic acid, such as adipic acid, or its derivative. This conductive adhesive is considered to be an inexpensive conductive adhesive with excellent conductivity and repairability as a solder alternative.
Patent literature 5 discloses a conductive adhesive including a Sn-containing conductive metal powder, a thermosetting resin, an acid anhydride-based curing agent, and an organic acid. The conductive metal powder and the organic acid react with each other during heating to generate an organic acid metal salt, which is used as a curing accelerator. This conductive adhesive is considered to be able to cure a thermosetting resin in a short time.

### Background Art Literature

### Patent Literature

Patent literature 1: Japanese Unexamined Patent Application Publication No. 2020-205245
Patent literature 2: Japanese Unexamined Patent Application Publication No. 2022-172874
Patent literature 3: Japanese Patent No. 6428716
Patent literature 4: Japanese Unexamined Patent Application Publication No. 2000-309773
Patent literature 5: International Publication No. WO 2015/019666

## Summary of Invention

### Problems to Be Solved by the Invention

Although a conductive resin composition containing a silver particle can form a conductive film with an excellent conductivity, a silver particle is very expensive and is disadvantageous in cost. In contrast, a conductive film formed from a conductive resin composition containing a conductive particle other than a silver particle has a high volume resistivity, and the conductivity may be insufficient. In addition, when a large amount of a conductive particle is contained for reducing the volume resistivity, the adhesion to various substrates may be insufficient.
A conductive resin composition containing a tin powder is known by Patent Literatures 2 to 5 and the like but is not satisfactory in terms of storage stability at room temperature and under refrigeration and in terms of volume resistivity when formed into a conductive film, and a conductive resin composition that satisfies high level demands, i.e., both excellent storage stability and excellent conductivity, has not been known.
One objective of the present invention is to provide a conductive resin composition containing a tin powder, and the conductive resin composition is excellent in room temperature (25°C) storage stability and refrigeration (4°C) storage stability, can form a conductive film having a low volume resistivity and an excellent conductivity, and is advantageous in cost.
One challenge of the present invention is to provide a conductive resin composition containing a tin powder, and the conductive resin composition is excellent in room temperature (25°C) storage stability and refrigeration (4°C) storage stability, can form a conductive film having a low volume resistivity and an excellent conductivity, has an excellent curing property without using a thiol-based epoxy resin curing agent, an amine-based epoxy resin curing agent, an acid anhydride-based epoxy resin curing agent, and a phenol-based epoxy resin curing agent, and is advantageous in cost.
One challenge of the present invention is to provide a conductive film with a low volume resistivity formed from the conductive resin composition, a conductive material including the conductive resin composition, a conductive adhesive including the conductive resin composition, and a circuit connection material including the conductive resin composition at low cost.

### Means for Solving the Problems

The present inventor has conducted extensive research to solve the above problems and, as a result, found that the above problems can be solved by a conductive resin composition having a specific composition, and the present invention was accomplished.
Specifically, the present invention is as follows:

[Item 1]

A conductive resin composition comprising:

a tin powder (a);
an epoxy resin (b); and
a dicarboxylic acid compound (c), wherein
the epoxy resin (b) includes an epoxy resin that has an epoxy equivalent of 400 g/eq or more and is in a solid or semisolid state at 25°C, and
the dicarboxylic acid compound (c) includes a dicarboxylic acid compound having 4 or more and 9 or less carbon atoms;

[Item 2]

The conductive resin composition according to Item 1, wherein a content of the tin powder (a) is 92.01 mass% or more and 99.50 mass% or less based on 100 mass% of the total amount of components other than the solvent in the conductive resin composition;

[Item 3]

The conductive resin composition according to Item 1 or 2, wherein the dicarboxylic acid compound (c) further includes a dicarboxylic acid compound having 10 or more carbon atoms;

[Item 4]

The conductive resin composition according to any one of Items 1 to 3, further comprising a thiol-based compound (d);

[Item 5]

A conductive film formed from the conductive resin composition according to any one of Items 1 to 4 and having a volume resistivity of less than $4.0 \times 10^{-4}$ Ω·cm;

[Item 6]

A conductive material comprising the conductive resin composition according to any one of Items 1 to 4;

[Item 7]

A conductive adhesive comprising the conductive resin composition according to any one of Items 1 to 4; and

[Item 8]

A circuit connection material comprising the conductive resin composition according to any one of Items 1 to 4.

**Effects of the Invention**

According to the present invention, provided is a conductive resin composition containing a tin powder, the conductive resin composition is excellent in room temperature (25°C) storage stability and refrigeration (4°C) storage stability, can form a conductive film having a low volume resistivity and an excellent conductivity, and is advantageous in cost.

According to the present invention, provided is a conductive resin composition containing a tin powder, and the conductive resin composition is excellent in room temperature (25°C) storage stability and refrigeration (4°C) storage stability, can form a conductive film having a low volume resistivity and an excellent conductivity, has an excellent curing property without using a thiol-based epoxy resin curing agent, an amine-based epoxy resin curing agent, an acid anhydride-based epoxy resin curing agent, and a phenol-based epoxy resin curing agent, and is advantageous in cost.

According to the present invention, provided at low cost are a conductive film with a low volume resistivity formed from the conductive resin composition, a conductive material including the conductive resin composition, a conductive adhesive including the conductive resin composition, and a circuit connection material including the conductive resin composition.

The conductive resin composition of the present invention is useful as a printed electronic material and is significantly useful in mass production of various electronic devices such as a display device, a vehicle-related part, IoT, and a mobile communication system.

**Mode for Carrying Out the Invention**

The present invention relates to a conductive resin composition, a conductive film, a conductive material, a conductive adhesive, and a circuit connection material. They will be described in detail below.

[Conductive resin composition]

<Tin powder (a)>

The tin powder (a) contained in a conductive resin composition of the present invention is a powder composed of 99.5 mass% or more of tin and may include a component (e.g., unavoidable impurities) other than tin. Examples of the tin powder (a) include a tin powder including only unavoidable impurities and a tin powder including 0.5 mass% or less of

components other than tin.

The content of tin in the tin powder (a) can be easily measured by using a fluorescent X-ray analysis (XRF) apparatus or the like.

The component other than tin that may be included in the tin powder (a) is, for example, one or more atoms selected from the group consisting of Mn, Sb, Si, K, Na, Li, Ba, Sr, Ca, Mg, Be, Zn, Pb, Cd, Tl, V, Al, Zr, W, Mo, Ti, Co, Ag, Cu, Ni, Au, B, C, N, O, Ge, Sb, In, As, Al, Fe, and like.

The content of other atoms in the tin powder (a) is preferably less than 0.3 mass% and more preferably 0.1 mass% or less.

The shape of the tin powder (a) is not particularly limited. For example, a scale-like (flake-like), flat, perfect spherical, approximately spherical (for example, the aspect ratio of length to width is 1.5 or less), block-like, plate-like, polygonal pyramid-like, polyhedral, rod-like, fibrous, needle-like, or irregular shape can be used depending on the purpose or the like. In the present invention, a scale-like, perfect spherical, approximately spherical, or flat shape is preferable from the viewpoint of volume resistivity, dispersibility, handleability, and the like.

When the tin powder (a) is spherical, the volume-average particle size (50% particle size D50 of cumulative frequency percent size in volume-based particle size distribution) is not particularly limited. D50 is, for example, 0.5 μm or more, preferably 1.0 μm or more, and more preferably 3.0 μm or more and is, for example, 300 μm or less, preferably 200 μm or less, and more preferably 100 μm or less. When D50 is 0.5 μm or more, the dispersibility and handleability of the tin powder (a) become better. When D50 is 300 μm or less, the volume resistivity can be reduced, and the dispersibility and handleability become better.

The measurement method of D50 is not particularly limited, and examples thereof include a laser diffraction scattering particle size distribution measurement method.

When the tin powder (a) is flat or scale-like, the average diameter, average thickness, and aspect ratio (average diameter/average thickness) are not particularly limited.

The average diameter is, for example, 0.5 μm or more, preferably 1.0 μm or more, more preferably 5.0 μm or more and is, for example, 500.0 μm or less, preferably 300.0 μm or less, and more preferably 150.0 μm or less.

The average thickness is, for example, 0.1 μm or more, preferably 0.5 μm or more, and more preferably 1.0 μm or more and is, for example, 50.0 μm or less, preferably 20.0 μm or less, and more preferably 10.0 μm or less.

The aspect ratio is, for example, 2 or more, preferably 10 or more, and more preferably 50 or more.

The method for measuring the average diameter and the average thickness are not particularly limited, but examples thereof include a method by a scanning electron microscope.

The content of the tin powder (a) in the conductive resin composition is not particularly limited, but the content based on 100 mass% of the total amount of components other than the solvent in the conductive resin composition is, for example, 88.00 mass% or more, preferably 90.10 mass% or more, and more preferably 92.01 mass% or more and is, for example, 99.50 mass% or less, preferably 99.00 mass% or less, and more preferably 98.00 mass% or less.

If the content of the tin powder (a) is less than 88.00 mass% based on 100 mass% of the total amount of components other than the solvent in the conductive resin composition, the conductivity decreases, and the volume resistivity may increase. If the content is greater than 99.50 mass%, there are risks that a film is not formed, the substrate adhesion is low, curing takes a long time, the dispersibility of the tin powder (a) decreases not to form a uniform composition, and the storage stability decreases.

<Epoxy resin (b)>

The epoxy resin (b) contained in the conductive resin composition of the present invention is not particularly limited as long as including an epoxy resin that includes two or more epoxy groups in the molecule, has an epoxy equivalent of 400 g/eq or more, and is in a solid or semisolid state at 25°C.

In the present invention, the epoxy resin that has an epoxy equivalent of 400 g/eq or more and is solid at 25°C is an epoxy resin not showing fluidity at 25°C and having a melting point or softening point of 25°C or more. The upper limit of the melting point or softening point is not particularly limited, but is, for example, preferably 150°C or less. Note that, in the present invention, the softening point is a value measured by a softening point test (ring and ball method) (measurement condition: conforming to JIS-K7234: 1986).

In the present invention, the epoxy resin that has an epoxy equivalent of 400 g/eq or more and is in a semisolid state at 25°C is an epoxy resin of which the symbol of Gardner's viscosity standard liquid at 25°C (measurement condition: concentration of 60%, butyl carbitol solvent, JIS K 5600) is Z-Z2.

Examples of the epoxy resin that has an epoxy equivalent of 400 g/eq or more and is in a solid or semisolid state at 25°C include a biphenyl-type epoxy resin; bisphenol-type epoxy resins such as a bisphenol A-type epoxy resin, a bisphenol F-type epoxy resin, a tetramethyl bisphenol F-type epoxy resin; a naphthalene-type epoxy resin; alkylene oxide-modified bisphenol-type resin; a chelate-modified epoxy resin; a stilbene-type epoxy resin; a glycol-type epoxy resin; a pentaerythritol-type epoxy resin; novolac-type epoxy resins such as a phenol novolac-type epoxy resin, a cresol novolac-type epoxy resin, and a bisphenol A novolac-type epoxy resin; multifunctional epoxy resins such as a trisphenolmethane-type epoxy resin and an alkyl-modified trisphenolmethane-type epoxy resin; aralkyl-type epoxy resins such as a phenol aralkyl-type epoxy resin having a phenylene skeleton and a phenol aralkyl-type epoxy resin having a biphenylene skeleton; naphthol-type epoxy resins such as a dihydroxynaphthalene-type epoxy resin and an epoxy resin obtained by glycidyl etherification of a dimer of dihydroxynaphthalene; triazine nucleus-containing epoxy resins such as triglycidyl isocyanurate and monoallyldiglycidyl isocyanurate; urethane-modified epoxy resins such as a resin obtained by reaction of a urethane bond-containing compound including an isocyanate group and a hydroxy group-containing epoxy compound; bridged cyclic hydrocarbon compound-modified phenol-type epoxy resins such as a dicyclopentadiene-modified phenol-type epoxy resin; a chelate-modified epoxy resin; a dimer acid-modified epoxy resin; a rubber-modified epoxy resin; a polysulfide-modified epoxy resin; a glycidylamine-type epoxy resin; and a glycidylester-type epoxy resin. Also, examples of the epoxy resin include alicyclic epoxy resins, for example, bisphenol compounds, such as bisphenol A, bisphenol F, and biphenol, or their derivatives among compounds including two or more glycidyl groups in one molecule, and epoxidized products of a polydiol having an alicyclic structure, such as hydrogenated bisphenol A, hydrogenated bisphenol F, hydrogenated biphenol, cyclohexanediol, cyclohexanedimethanol, and cyclohexanediethanol, or their derivatives; aliphatic epoxy resins such as epoxidized products of aliphatic polydiols, such as butanediol, hexanediol, octanediol, nonanediol, decanediol, and polybutadiene polyol, or their derivatives; an epoxy resin including a trihydroxyphenylmethane skeleton (trisphenolmethane skeleton); an aminophenol-type epoxy resin; a polyether-modified epoxy resin; a multifunctional aromatic epoxy resin; and a hydrogenated bisphenol-type epoxy resin. The epoxy resins may be used alone or in a combination of two or more.

The epoxy resin that has an epoxy equivalent of 400 g/eq or more and is in a solid or semisolid state at 25°C may be synthesized or may be a commercial product.

The commercial product of the epoxy resin that has an epoxy equivalent of 400 g/eq or more and is in a solid or semisolid state at 25°C is, for example, one or more selected from the group consisting of:

YD-011, YD-012, YD-013, YD-014, YD-017, YD-019, YD-901, YD-902, YD-903N, YD-904, YD-907, YD-7910, YDF-2001, and YDF-2004 manufactured by NIPPON STEEL Chemical & Material Co., Ltd.;
jER-4005P, jER-4007P, jER-4010P, and jER-1010 manufactured by Mitsubishi Chemical Corporation;
EPICLON 5500, EPICLON 5800, EPICLON 1050, EPICLON 1055, EPICLON 3050,
EPICLON 4050, EPICLON 7050, EPICLON AM-030-P, EPICLON AM-040-P,
EPICLON HM-091, and EPICLON TSR-601 manufactured by DIC Corporation;
LCE-2615 manufactured by Nippon Kayaku Co., Ltd.; and the like.

In the present invention, the epoxy resin (b) may contain an epoxy resin (i) that is liquid at 25°C and/or an epoxy resin (ii) that has an epoxy equivalent of less than 400 g/eq and is in a solid or semisolid state at 25°C.

Examples of the epoxy resin include a bisphenol-type epoxy resin, a naphthalene-type epoxy resin, a glycidylester-type epoxy resin, a glycidylamine-type epoxy resin, a phenol novolac-type epoxy resin, an alicyclic epoxy resin such as an alicyclic epoxy resin including an ester skeleton, a cyclohexane-type epoxy resin, a cyclohexanedimethanol-type epoxy resin, a glycidylamine-type epoxy resin, an epoxy resin having a structure of an epoxidized products of polybutadiene polyol, a rubber-modified epoxy resin, a chelate-modified epoxy resin, a urethane-modified epoxy resin, and a polysulfide-modified epoxy resin. Preferably, the epoxy resin is one or more selected from the group consisting of a bisphenol-type epoxy resin, a rubber-modified epoxy resin, an alicyclic epoxy resin, a glycidylamine-type epoxy resin, a urethane-modified epoxy resin, a polysulfide-modified epoxy resin, a chelate-modified epoxy resin, a trisphenolmethane-type epoxy resin, and a dicyclopentadiene-modified epoxy resin.

The content of the epoxy resin (b) in the conductive resin composition is not particularly limited. The content based on 100 mass% of the total amount of components other than the solvent in the conductive resin composition is, for example, 0.1 mass% or more, preferably 0.5 mass% or more, and more preferably 1.0 mass% or more and is, for example, 10.0 mass% or less, preferably 9.0 mass% or less, and more preferably 8.0 mass% or less.

If the content of the epoxy resin (b) is less than 0.1 mass% based on 100 mass% of the total amount of components other than the solvent in the conductive resin composition, there are risks that a film is not formed, curing takes a long time, the dispersibility of the tin powder decreases not to form a uniform composition, and the like. A content of greater than 10.0 mass% may cause a decrease in the conductivity to increase the volume resistivity.

The content of the epoxy resin that has an epoxy equivalent of 400 g/eq or more and is in a solid or semisolid state at 25°C in the epoxy resin (b) can be, based on 100 mass% of the total amount of the epoxy resin (b), for example, 10 mass% or more, preferably 25 mass% or more, and more preferably 50 mass% or more and 100 mass% (using only an epoxy resin having an epoxy equivalent of 400 g/eq or more and being in a solid or semisolid state at 25°C) or less.

<Dicarboxylic acid compound (c)>

The dicarboxylic acid compound (c) is represented by, for example, R-$(COOH)_2$ (in the formula, R is hydrogen or an organic group having 1 to 50 carbon atoms, and R may include an oxygen atom, a nitrogen atom, or a sulfur atom). In the present invention, the dicarboxylic acid compound (c) includes a dicarboxylic acid compound having 4 or more and 9 or less carbon atoms.

The dicarboxylic acid compound having 4 or more and 9 or less carbon atoms is, for example, one or more selected from the group consisting of succinic acid, glutaric acid, adipic acid, pimelic acid, suberic acid, azelaic acid, maleic acid, fumaric acid, citraconic acid, glutaconic acid, itaconic acid, mesaconic acid, 2-pentenedioic acid, methylenesuccinic acid, allylmaloic acid, hexadienedioic acid, terephthalic acid, isophthalic acid, o-phthalic acid, 1,4-cyclohexyldicarboxylic acid, malic acid, tartaric acid, 2,4-diethylglutaric acid, diglycolic acid, glutamic acid, aspartic acid, thiodiglycolic acid, and the like. Among these, preferred are aliphatic dicarboxylic acid compounds having 4 or more and 9 or less carbon atoms, more preferred are aliphatic dicarboxylic acid compounds having 5 or more and 9 or less carbon atoms, and further preferred are aliphatic dicarboxylic acid compounds having 6 or more and 8 or less carbon atoms. The aliphatic groups in the aliphatic dicarboxylic acids having 4 or more and 9 or less carbon atoms may be straight-chain or branched-chain.

In the present invention, the dicarboxylic acid compound (c) may include a dicarboxylic acid (such as a dicarboxylic acid compound having 2 or 3 carbon atoms and a dicarboxylic acid compound having 10 or more carbon atoms) other than the dicarboxylic acid compound having 4 or more and 9 or less carbon atoms.

The dicarboxylic acid compound having 2 or 3 carbon atoms is, for example, one or more selected from the group consisting of oxalic acid, malonic acid, and the like.

The dicarboxylic acid compound having 10 or more carbon atoms is, for example, one or more selected from the group consisting of sebacic acid, undecanedioic acid, dodecanedioic acid, tridecanedioic acid, tetradecanedioic acid, pentadecanedioic acid, hexadecanedioic acid, heptadecanedioic acid, octadecanedioic acid, eicosanedioic acid, nonadecanedioic acid, docosanedioic acid, eicosadienedioic acid, isoeicosanedioic acid, isodocosanedioic acid, isodocosadienedioic acid, butyloctanedioic acid, 2-methylazelaic acid, dimethylmethoxycarbonylundecanedioic acid, dimethyldimethoxycarbonylhexadecanedioic acid, trimethyldimethoxycarbonyltridecanedioic acid, dodecenylsuccinic acid, naphthalenedicarboxylic acid, straight-chain or branched-chain dicarboxylic acids (for example, SL-12, SL-20, UL-20, MMA-10R, SB-12, IPU-22, IPS-22, SB-20, and UB-20 manufactured by Okamura Oil Mill, Ltd.), and the like.

The use of a dicarboxylic acid compound including a dicarboxylic acid compound having 4 or more and 9 or less carbon atoms as the dicarboxylic acid compound (c) can improve the dispersibility or the like of the tin powder, can increase the content of the tin powder, and can enhance the conductivity.

The content of the dicarboxylic acid compound (c) in the conductive resin composition is not particularly limited. The content based on 100 mass% of the total amount of components other than the solvent in the conductive resin composition is, for example, 0.1 mass% or more, preferably 0.3 mass% or more, and more preferably 0.5 mass% or more and is, for example, 4.0 mass% or less, preferably 3.5 mass% or less, and more preferably 3.0 mass% or less.

If the content of the dicarboxylic acid compound (c) is less than 0.1 mass% based on 100 mass% of the total amount of components other than the solvent in the conductive resin composition, there are risks that a film is not formed, curing takes a long time, the dispersibility of the tin powder decreases not to form a uniform composition, and the like. A content of greater than 4.0 mass% may cause, for example, a decrease in the conductivity to increase the volume resistivity and a decrease in the storage stability.

The content of the dicarboxylic acid compound having 4 or more and 9 or less carbon atoms in the dicarboxylic acid compound (c) based on 100 mass% of the total amount of the dicarboxylic acid compound (c) is, for example, 10 mass% or more, preferably 25 mass% or more, and more preferably 50 mass% or more and can be 100 mass% (using only a dicarboxylic acid compound having 4 or more and 9 or less carbon atoms) or less.

<Thiol-based compound (d)>

The conductive resin composition of the present invention may further contain a thiol-based compound (d). The thiol-based compound (d) can function as a curing agent for the epoxy resin (b) in the conductive resin composition and can make curing of the conductive resin composition proceed faster and more reliably.

The thiol-based compound (d) may be one or more compounds including one or more, preferably two or more, thiol groups that can react with epoxy groups in the molecule. The number of thiol groups in one molecule of the thiol-based compound (d) is more preferably from two to six (difunctional to hexafunctional) and further preferably from three to six (trifunctional to hexafunctional).

The thiol-based compound (d) is, for example, one or more selected from the group consisting of trimethylolpropane tris(3-mercaptopropionate) (abbreviation: TMTP), pentaerythritol tetrakis(3-mercaptopropionate) (abbreviation: PEMP), dipentaerythritol hexakis(3-mercaptopropionate) (abbreviation: DPMP), tris-[(3-mercaptopropionyloxy)-ethyl]-isocyanurate (abbreviation: TEMPIC), tris(3-mercaptopropyl) isocyanurate (abbreviation: TMPIC), ethylene glycol bisthioglycolate (abbreviation: EGTG), trimethylolpropane tristhioglycolate (abbreviation: TMTG), pentaerythritol tetrakisthioglycolate (abbreviation: PETG), pentaerythritol tetrakis(3-mercaptobutyrate), 1,4-bis(3-mercaptobutyryloxy)butane, 1,3,5-tris(3-mercaptobutyryloxyethyl)-1,3,5-triazine-2,4,6(1H,3H,5H)-trione, trimethylolpropane tris(3-mercaptobutyrate) (abbreviation: TPMB), trimethylolethane tris(3-mercaptobutyrate) (abbreviation: TEMB), 1,3,4,6-tetrakis(2-mercaptoethyl)glycoluril, 1,3,4,6-tetrakis(2-mercaptopropyl)glycoluril, 4,4'-isopropylidene bis[(3-mercaptopropoxy)benzene], thiocyanuric acid (1,3,5-triazine-2,4,6-trithiol), a polysulfide polymer with a thiol group, and the like.

Specifically, examples include thiol-based compounds (such as TMMP-LV, PEMP-LV, DPMP, TEMPIC, and PEMP) manufactured by SC Organic Chemical Co., Ltd., thiol-based compounds (such as QE-340M, LP-3, LP-55, and LP-31) manufactured by Toray Fine Chemicals Co., Ltd., thiol-based compounds (such as TS-G and C3TS-G) manufactured by Shikoku Chemicals Corporation, thiol-based compounds (such as PE-1, BD-1, NR-1, TPMB, and TEMB) manufactured by Resonac Corporation, thiol-based compounds (such as OTG, EGTG, TMTG, PETG, 3-MPA, TMTP, and PETP) manufactured by Yodo Kagaku Co., Ltd., and thiol-based compounds (such as TEMP, PEMP, TEMPIC, and DPMP) manufactured by Sakai Chemical Industry Co., Ltd.

The content of the thiol-based compound (d) in the conductive resin composition is not particularly limited. In the present invention, it is possible to cure the conductive resin composition without using the thiol-based compound (d).

When the thiol-based compound (d) is contained, preferably, the content thereof is such that the amount of the thiol group (-SH group) in the thiol-based compound (d) based on 1 equivalent of the epoxy group of the epoxy resin is, for example, 0.05 equivalent or more, preferably 0.10 equivalent or more, and more preferably 0.15 equivalent or more and, for example, 4.00 equivalent or less, preferably 3.50 equivalent or less, and more preferably 1.50 equivalent or less. When the content of the thiol-based compound (d) is greater than 4.00 equivalent, poor curing of the coating film occurs by the influence of unreacted excessive curing agent, and the coating film hardness may decrease.

In addition, when the thiol-based compound (d) is contained, the content based on 100 parts by mass of the epoxy resin can be, for example, 1.0 parts by mass or more, preferably 1.5 parts by mass or more, and more preferably 2.0 parts by mass or more and can be, for example, 250 parts by mass or less, preferably 200 parts by mass or less, and more preferably 180 parts by mass or less. When the content of the thiol-based compound (d) based on 100 parts by mass of the epoxy resin is greater than 250 parts by mass, the conductive resin composition may not become solid.

<Solvent (e)>

The conductive resin composition of the present invention may further contain a solvent (e). Consequently, the fluidity of the conductive resin composition is improved, resulting in contribution to improvement in the workability. In addition, a conductive resin paste, a conductive material, a conductive adhesive, or circuit connection material can be constituted by mixing the conductive resin composition and the solvent.

As the solvent, arbitrary one or more selected from the group consisting of water and various organic solvents can be used. The organic solvent is, for example, one or more selected from the group consisting of alcohol-based solvents and alcohol ether-based solvents, such as ethyl alcohol, propyl alcohol, butyl alcohol, pentyl alcohol, hexyl alcohol, heptyl alcohol, octyl alcohol, nonyl alcohol, decyl alcohol, ethylene glycol monomethyl ether, ethylene glycol monoethyl ether, ethylene glycol monopropyl ether, ethylene glycol monobutyl ether, diethylene glycol monobutyl ether, diethylene glycol dibutyl ether, propylene glycol monomethyl ether, propylene glycol monoethyl ether, propylene glycol monopropyl ether, propylene glycol monobutyl ether, methyl methoxy butanol, α-terpineol, β-terpineol, hexylene glycol, benzyl alcohol, 2-phenylethyl alcohol, isopalmityl alcohol, isostearyl alcohol, lauryl alcohol, ethylene glycol, propylene glycol, and glycerin; ketone-based solvents, such as acetone, methyl ethyl ketone, methyl isobutyl ketone, cyclohexanone, diacetone alcohol (4-hydroxy-4-methyl-2-pentanone), 2-octanone, isophorone (3,5,5-trimethyl-2-cyclohexen-1-one), and diisobutyl ketone (2,6-dimethyl-4-heptanone); ester-based solvents, such as ethyl acetate, butyl acetate, diethyl phthalate, dibutyl phthalate, acetoxy ethane, methyl butyrate, methyl hexanoate, methyl octanoate, methyl decanoate, methyl cellosolve acetate, ethylene glycol monobutyl ether acetate, propylene glycol monomethyl ether acetate, and 1,2-diacetoxyethane; ether-based solvents, such as tetrahydrofuran, dimethyl ether, diethyl ether, dipropyl ether, ethylene glycol dimethyl ether, ethylene glycol diethyl ether, ethylene glycol dibutyl ether, propylene glycol dimethyl ether, ethoxy ethyl ether, 1,2-bis(2-diethoxy)ethane, and 1,2-bis(2-methoxyethoxy)ethane; ester ethers, such as 2-(2-butoxyethoxy)ethane acetate; ether-alcohol-based solvents, such as 2-(2-methoxyethoxy)ethanol; hydrocarbon-based solvents, such as benzene, toluene, xylene, n-paraffin, isoparaffin, dodecyl benzene, turpentine oil, kerosene, and light oil; nitrile-based solvents, such as acetonitrile and propionitrile; nitrogen-containing polar solvents, such as dimethyl acetoamide, N,N-dimethylformamide, and N-methyl-2-pyrrolidone; and silicon oil-based solvents.

Among these, preferred are one or more selected from the group consisting of alcohol-based solvents, alcohol ether-based solvents, ether-based solvents, ester-based solvents, and ketone-based solvents; more preferred are one or more selected from the group consisting of alcohol ether-based solvents, ether-based solvents, ester-based solvents, and ketone-based solvents; and further preferred are one or more selected from the group consisting of alcohol ether-based solvents, ether-based solvents, and ester-based solvents.

The amount of the organic solvent to be used is not particularly limited and may be appropriately adjusted to give a viscosity such that the conductive resin composition can be adequately applied or printed on a substrate and/or can be adequately impregnated in a porous material.

<Other component (f)>

The conductive resin composition of the present invention can contain, as needed, one or more additives selected from the group consisting of an organic acid compound, an epoxy resin curing agent, an epoxy resin curing accelerator, a conductive powder other than the tin powder, an adhesion imparting agent, a viscoelasticity-adjusting agent, a wetting and dispersing agent, a reactive diluent, a resin other than the epoxy resin, a pigment, a filler, an antioxidant, an anticorrosive agent, a defoaming agent, a coupling agent, an anti-settling agent, a leveling agent, a heavy metal inactivator, a gap adjustor, and the like, as "other component (f)", in addition to the above (a) to (e).

(Organic acid compound)

The organic acid compound is an organic acid compound other than the dicarboxylic acid compound and is, for example, one or two or more organic acid compounds represented by $R\text{-}X_n$ (in the formula, R is hydrogen or an organic group having 1 to 50 carbon atoms, X is an acid group, a plurality of Xs may be different from one another, and n is an integer of 1 or more).

Examples of the acid group represented by X include a carboxyl group (-COOH), a sulfonate group ($-SO_3H$), and a phosphate group ($-PO_4H_2$).

The organic acid compound is, for example, one or more selected from the group consisting of an organic carboxylic acid compound other than the dicarboxylic acid compound, an organic sulfonic acid compound, and an organic phosphonic acid compound. Preferred is an organic carboxylic acid compound other than the dicarboxylic acid compound.

{Organic carboxylic acid compound}

The organic carboxylic acid compound is not particularly limited as long as it is a compound having 1 to 50 carbon atoms and including one or three or more carboxyl groups (-COOH) in the molecular structure.

The organic carboxylic acid compound is, for example, one or more selected from the group consisting of formic acid, acetic acid, propionic acid, butanoic acid, pentanoic acid, hexanoic acid, heptanoic acid, octylic acid, caproic acid, enanthic acid, caprylic acid, pelargonic acid, capric acid, lauric acid, myristic acid, pentadecylic acid, palmitic acid, margaric acid, stearic acid, 12-hydroxystearic acid, ricinoleic acid, oleic acid, vaccenic acid, linoleic acid, linolenic acid, arachidic acid, behenic acid, lignoceric acid, cerotic acid, montanic acid, melissic acid, behenic acid, arachidonic acid, eicosapentaenoic acid, docosahexaenoic acid, lactic acid, gluconic acid, citric acid, ascorbic acid, abietic acid, dimethylolpropionic acid, dimethylolbutanoic acid, dimethylolbutyric acid, dimethylolvaleric acid, trimethylolpropanoic acid, trimethylolbutanoic acid, benzoic acid, salicylic acid, pyruvic acid, paramethylbenzoic acid, toluic acid, 4-ethylbenzoic acid, 4-propylbenzoic acid, 2-methylpropanoic acid, isopentanoic acid, 2-ethylhexanoic acid, acrylic acid, methacrylic acid, propiolic acid, crotonic acid, 2-ethyl-2-butenoic acid, hexanetricarboxylic acid, cyclohexyl carboxylic acid, ethylenediaminetetraacetic acid, trimellitic acid, pyromellitic acid, monomethyl glutarate, glycolic acid, isoleucine, leucine, lysine, methionine, phenylalanine, threonine, tryptophan, valine, histidine, tyrosine, cysteine, asparagine, serine, glutamine, proline, glycine, alanine, arginine, and the like.

{Organic sulfonic acid compound}

The organic sulfonic acid compound is not particularly limited as long as it is a compound including one or more sulfonate groups ($-SO_3H$) in the molecular structure.

Examples include one or more selected from the group consisting of aromatic sulfonic acid compounds, such as benzenesulfonic acid, n-butylbenzenesulfonic acid, n-octylbenzenesulfonic acid, n-dodecylbenzenesulfonic acid, pentadecylbenzenesulfonic acid, 2,5-dimethylbenzenesulfonic acid, p-chlorobenzenesulfonic acid, 2,5-dichlorobenzenesulfonic acid, p-phenolsulfonic acid, cumenesulfonic acid, xylenesulfonic acid, o-cresolsulfonic acid, m-cresolsulfonic acid, p-cresolsulfonic acid, p-toluenesulfonic acid, 2-naphthalenesulfonic acid, 1-naphthalenesulfonic acid, styrenesulfonic acid, 4,4-biphenyldisulfonic acid, anthraquinone-2-sulfonic acid, m-benzenedisulfonic acid, aniline-2,4-disulfonic acid, anthraquinone-1,5-disulfonic acid, and polystyrenesulfonic acid; aliphatic sulfonic acid compounds, such as methanesulfonic acid, ethanesulfonic acid, 1-propanesulfonic acid, n-octylsulfonic acid, pentadecylsulfonic acid, trifluoromethanesulfonic acid, trichloromethanesulfonic acid, 1,2-ethanedisulfonic acid, 1,3-propanedisulfonic acid, aminomethanesulfonic acid, and 2-aminoethanesulfonic acid; and cyclopentanesulfonic acid, cyclohexanesulfonic acid, and 3-cyclohexylaminopropanesulfonic acid alicyclic sulfonic acid compounds; and the like.

Preferable are one or more selected from the group consisting of benzenesulfonic acid, dodecylbenzenesulfonic acid, methanesulfonic acid, p-phenolsulfonic acid, p-toluenesulfonic acid, (poly)styrenesulfonic acid, and the like.

{Organic phosphonic acid compound}

The organic phosphonic acid compound is not particularly limited as long as it is a compound having one or more phosphonate group ($-PO_3H_2$) in the molecular structure.

Examples include one or more selected from the group consisting of 1-hydroxyethylidene-1,1-diphosphonic acid, 1-hydroxypropylidene-1,1-diphosphonic acid, 1-hydroxybutylidene-1,1-diphosphonic acid, aminotrimethylene phosphonic acid, methyldiphosphonic acid, nitrotrismethylene phosphonic acid, ethylenediamine tetramethylene phosphonic acid, ethylenediamine bismethylene phosphonic acid, hexamethylenediamine tetramethylene phosphonic acid, diethylenetriamine pentamethylene phosphonic acid, cyclohexanediamine tetramethylene phosphonic acid, carboxydiethyl phosphonic acid, phosphonoacetic acid, 2-phosphonobutane-1,2,4-tricarbonic acid, 2,3-dicarboxypropane-1,1-diphosphonic acid, phosphonobutyric acid, phosphonopropionic acid, sulfonylmethyl phosphonic acid, N-carboxymethyl-N,N-dimethylene phosphonic acid, N,N-dicarboxymethyl-N-methylene phosphonic acid, 2-ethylhexyl acid phosphate, stearyl acid phosphate, benzenephosphonic acid, and the like.

The organic phosphonic acid compound maybe a surfactant having a phosphate group ($-PO_4H_2$) in the molecular structure.

The surfactant having a phosphate group preferably includes a polyoxyethylene group or a phenyl group in the molecular structure. Examples include one or more selected from the group consisting of polyoxyethylene alkyl phenyl ether phosphoric acid, polyoxyethylene alkyl ether phosphoric acid, dipolyoxypropylene lauryl ether phosphoric acid, dipolyoxyethylene oleyl ether phosphoric acid, dipolyoxyethylene oxypropylene lauryl ether phosphoric acid, dipolyoxypropylene oleyl ether phosphoric acid, ammonium lauryl phosphate, ammonium octyl ether phosphate, ammonium cetyl ether phosphate, polyoxyethylene lauryl ether phosphoric acid, polyoxyethylene oxypropylene lauryl ether phosphoric acid, polyoxypropylene lauryl ether phosphoric acid, polyoxyethylene tristyrylphenyl ether phosphoric acid, polyoxyethylene oxypropylene tristyrylphenyl ether phosphoric acid, polyoxypropylene tristyrylphenyl ether phosphoric acid, and the like.

As the surfactant including a phosphate group, one or more selected from the group consisting of commercial products, such as trade name: Phosphanol manufactured by Toho Chemical Industry Co., Ltd. and DISPERBYK manufactured by BYK Japan KK, can be used.

(Epoxy resin curing agent)

The conductive resin composition of the present invention may contain an epoxy resin curing agent other than the thiol-based compound (d). Consequently, the curing property of the conductive resin composition is improved, resulting in contribution to improvement in the bonding strength or the like. Examples of the epoxy resin curing agent include an amine-based curing agent, an acid anhydride-based curing agent, and a phenol-based curing agent. These may be used alone or in a combination of two or more. The conductive resin composition of the present invention preferably includes a curing agent that is liquid at 20°C, from the viewpoint of improving more effectively the workability, handleability, and the like.

{Amine-based curing agent}

Examples of the amine-based curing agent include diethylenetriamine, triethylenetetramine, diethylaminopropylamine, menthanediamine, isophoronediamine, bis[4-amino-3-methyldicyclohexyl]methane, diaminodicyclohexylmethane, bis(aminomethyl)cyclohexane, m-xylylenediamine, metaphenylenediamine, diaminodiphenylmethane, diaminodiethyldiphenylmethane, and their modified polyamines, polyamidoamines, and the like modified by epoxy adduction, Michael adduction, Mannich reaction, and the like. These agents may be used alone or in a combination of two or more.

{Acid anhydride-based curing agent}

The acid anhydride-based curing agent is not particularly limited as long as it is a compound having one or more carboxylic anhydride group (-C(=O)-O-C(=O)-) in the molecular structure.

The acid anhydride-based curing agent is obtained by dehydration between two organic carboxylic acid molecules and/or intramolecular dehydration of one organic carboxylic acid molecule. In the present invention, among the above-mentioned organic carboxylic acids, examples include one or more selected from the group consisting of those obtained by dehydration between organic monocarboxylic acid molecules and those obtained by intramolecular and/or intermolecular dehydration of an organic polycarboxylic acid. Examples include an aliphatic monocarboxylic anhydride, an aliphatic polycarboxylic anhydride, an alicyclic polycarboxylic anhydride, an aromatic polycarboxylic anhydride, and

the like.

Preferable are one or more selected from the group consisting of acetic anhydride, glutaric anhydride, propionic anhydride, oxalic anhydride, maleic anhydride, phthalic anhydride, benzoic anhydride, succinic anhydride, 2-methylsuccinic anhydride, trimellitic anhydride, pyromellitic anhydride, tetrahydrophthalic anhydride, methyltetrahydrophthalic anhydride, hexahydrophthalic anhydride, methylhexahydrophthalic anhydride, (poly)adipic anhydride, (poly)azelaic anhydride, (poly)sebacic anhydride, norbornene-2,3-dicarboxylic anhydride, methyl-5-norbornene-2,3-dicarboxylic anhydride, and the like.

In the present invention, one or more polyacid polyanhydrides represented by the following structural formula (1):

[Chem. 1]

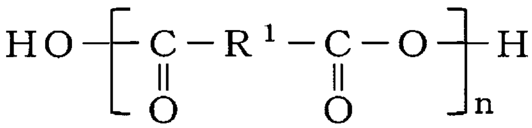

· · · (1)

(in the structural formula (1), $R^1$ is a straight-chain or branched-chain hydrocarbon group having 10 or more carbon atoms) may be used as the acid anhydride-based curing agent. Such a polyacid polyanhydride is obtained by intramolecular dehydration condensation reaction of a long-chain aliphatic dicarboxylic acid. Examples include SL-12AH, SL-20AH, SB-20AH, IPU-22AH, ST-2PAH, and the like manufactured by Okamura Oil Mill, Ltd. In particular, SB-20AH, IPU-22AH, and ST-2PAH that are liquid at 25°C are preferably used.

{Phenol-based curing agent}

Examples of the phenol-based curing agent include compounds having one or more, preferably two or more, phenolic hydroxy groups, that can react with an epoxy group, in the molecule, and examples thereof include bisphenols, such as bisphenol A, bisphenol B, bisphenol F, bisphenol AD, and bisphenol S; biphenols, such as biphenol and tetramethylbiphenol; phenols, such as hydroxyphenol and bis(4-hydroxyphenyl)ether; alkylphenols; phenol novolac, such as 2,6-bis[(2-hydroxyphenyl)methyl]-phenol and phenol biphenylene novolac (biphenyl aralkylphenol); cresol novolac, such as o-cresol novolac, m-cresol novolac, and p-cresol novolac; phenol resins; and the like. These may be used alone or in a combination of two or more.

{Content of epoxy resin curing agent}

In the conductive resin composition of the present invention, the content of the epoxy resin curing agent is not particularly limited. In the present invention, it is possible to cure the conductive resin composition without using a curing agent.

When a curing agent is contained, the amount of the group that reacts with the epoxy group in the curing agent (e.g., a hydroxy group, an amino group, or a carboxyl group (formed from an acid anhydride group)) based on 1 equivalent of the epoxy group of the epoxy resin is, for example, 0.7 equivalent or more, preferably 0.8 equivalent or more, and more preferably 0.9 equivalent or more and is, for example, 1.3 equivalent or less, preferably 1.2 equivalent or less, and more preferably 1.1 equivalent or less. When the amount is greater than 1.3 equivalent, poor curing of the coating film occurs by the influence of unreacted excessive curing agent, and the coating film hardness may decrease. 1.0 equivalent is most preferable.

(Epoxy resin curing accelerator)

The conductive resin composition of the present invention may contain a curing accelerator (curing catalyst) for accelerating the curing of the epoxy resin. The curing accelerator is not particularly limited, but examples thereof include an amine-based curing accelerator, a guanidine-based curing accelerator, an imidazole-based curing accelerator, and a phosphonium-based curing accelerator. These may be used alone or in a combination of two or more. Examples include ethylene amines, such as ethylene diamine, diethylene triamine, triethylene tetramine, tetraethylene pentamine, and pentaethylene hexamine; aliphatic tertiary amines, such as triethylamine, tripropylamine, tributylamine, dimethylbutylamine, dimethylpentylamine, and dimethylcyclohexylamine; and dimethylbenzylamine, dimethylaminomethylphenol, dimethylamino-p-cresol, piperidine, α-picoline, pyridine, 2,4,6-tris(dimethylaminomethyl)phenol, 3,4,5-tris(dimethylaminomethyl)phenol, 2-methylimidazole, 2-ethyl-4-methylimidazole, 2-undecylimidazole, 2-phenylimidazole, 1-benzyl-2-methylimidazole, 1-cyanoethyl-2-methylimidazole, 1-cyanoethyl-2-ethyl-4-methylimidazole, N-aminoethylpiperazine, 1,3,6-trisaminomethylhexane, m-xylenediamine, p-xylenediamine, N-(2-aminoethyl)piperazine, m-phenylenediamine,

p-phenylenediamine, diaminophenylmethane, methylenedianiline, 2,4-toluenediamine, 2,4-diaminoanisole, 2,4-toluenediamine, 2,4-diaminodiphenylamine, 4,4'-methylenedianiline, 1,3-diaminocyclohexane, 3,9-bis(3-aminopropyl)-2,4,8,10-tetrapyro[5,5]undecane, 1,8-diazabicyclo[5,4,0]undecene-7 or polyamine, polyamidoamine, polyamide, modified polyamine, modified polyamidoamine, and modified polyamide. These curing accelerators may be used alone or in a combination of two or more.

(Conductive powder other than tin powder)

The conductive resin composition of the present invention may contain a conductive powder other than the tin powder. Examples of such a conductive powder include a lead-free solder powder, a gold powder, a silver powder, a copper powder, a silver-coated copper powder, a silver-coated silica powder, a silver-coated nickel powder, a resin-core metal-coated fine particle, a nickel powder, and a conductive carbon powder.

For example, the lead-free solder powder is not particularly limited as long as it is a powder of solder not containing lead in an amount higher than that is inevitably contained, from the influence on workers, users, the environment, and the like. The melting point of the lead-free solder powder is preferably 300°C or less, more preferably 240°C or less, and further preferably from 50°C to 240°C. If the lead-free solder powder has a melting point of higher than 300°C, the connected members, such as a circuit board and an electronic component, may be thermally destructed or deteriorated. If the melting point is lower than 50°C, the mechanical strength decreases, and the reliability of the conductive connection may decrease.

(Adhesion imparting agent)

The conductive resin composition of the present invention may contain an adhesion imparting agent. Consequently, when the conductive resin composition is applied to a substrate, adhesion and the like with the substrate can be improved. Examples of the adhesion imparting agent include a triazole compound, a thiazole compound, a triazine compound, a porphyrin compound, a polymer having a functional group (such as a carboxylic acid group, an amino group, or a hydroxy group) or its salt. These may be used alone or in a combination of two or more.

As the adhesion imparting agent, for example, BYK series (4509, 4510, 4512, and the like) manufactured by BYK Japan KK are exemplified.

(Viscoelasticity-adjusting agent)

The conductive resin composition of the present invention may contain a viscoelasticity-adjusting agent (rheology control agent). Consequently, the viscoelasticity (rheology) of the conductive resin composition is adjusted, resulting in contribution to improvement in the workability and the like.

Examples of the viscoelasticity-adjusting agent (rheology control agent) include polyamide-based, aminoplast-based, polycarboxylic acid-based, urethane-based, cellulose-based, and inorganic layered compound-based viscoelasticity-adjusting agents (rheology control agents). Examples thereof include RHEOBYK series (H370, H400, H600, H600VF, 100, 405, 410, 411, 415, 430, 431, 440, 7410ET, and the like) manufactured by BYK Japan KK; Disparlon series (AQ-600, AQH-800, 3600N, 3900EF, and the like) manufactured by Kusumoto Chemicals, Ltd.; SN Thickener series (613, 617, 618, 630, 634, 636, 621N, 623N, and the like) manufactured by San Napco Limited; ADEKANOL series (UH-814N, UH-752, UH-750, UH-462, and the like) manufactured by ADEKA Corporation; HEC DAICEL series (SP600N and the like) manufactured by DAICEL Corporation; and BENTONE HD and the like manufactured by Elementis Japan KK. These may be used alone or in a combination of two or more.

(Wetting and dispersing agent)

The conductive resin composition of the present invention may contain a dispersing agent, as needed, for preventing aggregation of the tin powder.

Specific examples of the wetting and dispersing agent include Solsperse series (9000, 12000, 17000, 20000, 21000, 24000, 26000, 27000, 28000, 32000, 35100, 54000, and the like) manufactured by Lubrizol Japan Ltd.; EFKA series (4008, 4009, 4010, 4015, 4046, 4047, 4060, 4080, 7462, 4020, 4050, 4055, 4400, 4401, 4402, 4403, 4300, 4330, 4340, 6220, 6225, 6700, 6780, 6782, 8503, and the like) manufactured by EFKA Additives, B.V.; AJISPER series (PA111, PB711, PB821, PB822, PN411, and the like) manufactured by Ajinomoto Fine-Techno Co., Inc.; and DISPERBYK series (101, 106, 108, 116, 130, 140, 145, 161, 163, 166, 168, 171, 180, 192, 2000, 2001, 2020, 2025, 2070, 2152, 2155, 2164, 220S, 300, 320, 340, 378, 380N, 410, 425, 430, and the like) manufactured by BYK Japan KK. These may be used alone or in a combination of two or more.

(Reactive diluent)

A curable resin composition of the present invention may contain a reactive diluent for adjusting the viscosity, curing property, and the like of the conductive resin composition. The reactive diluent is not particularly limited, but is, for example, one or more of a compound having one epoxy group in the molecular structure, a compound having one or more oxetane groups in the molecular structure, and the like. Examples include glycidyl phenyl ether, glycidyl lauryl ether, 2-phenylphenol glycidyl ether, allyl glycidyl ether, 4-tertbutyl phenyl glycidyl ether, N-glycidyl phthalimide, 2-ethylhexyl glycidyl ether, and 2-ethylhexyl glycidyl ether; YED111N, YED111AN, and YED188 manufactured by Mitsubishi Chemical Corporation; ADEKA Glycirol ED-502, ADEKA Glycirol ED-502S, ADEKA Glycirol ED-509E, ADEKA Glycirol ED-509S, and ADEKA Glycirol ED-529 manufactured by ADEKA Corporation; Denacol EX-145, Denacol EX-171, and Denacol EX-192 manufactured by Nagase ChemteX Corporation; Epolite M-1230 and Epolite 100MF manufactured by Kyoeisha Chemical Co., Ltd.; Aron Oxetane OXT- 101, Aron Oxetane OXT-212, Aron Oxetane OXT-121, and Aron Oxetane OXT-221 manufactured by Toagosei Co., Ltd.; and ETERNACOLL EHO, ETERNACOLL HBOX, ETERNACOLL OXMA, and ETERNACOLL OXBP manufactured by UBE Corporation. These may be used alone or in a combination of two or more.

(Resin other than epoxy resin)

The conductive resin composition of the present invention may contain a resin other than the epoxy resin. This resin may be either thermoplastic or thermosetting resins, and a single resin or two or more resins may be used.

The thermoplastic resin is, for example, one or more selected from the group consisting of a polyvinyl acetal-based resin, an acrylic resin, a polyester-based resin, a phenoxy resin, a polyimide-based resin, a polyolefin-based resin, a thermoplastic polyurethane-based resin, a polyamide-based resin, a polycarbonate-based resin, a polyphenylene ether-based resin, a polyvinyl ether-based resin, a polyvinyl alcohol-based resin, a polyvinyl acetate-based resin, an ionomer resin, a block urethane resin, and the like.

The thermosetting resin is, for example, one or more selected from the group consisting of a resole-type phenol-based resin, a polyimide-based resin, a xylene-based resin, a polyurethane-based resin, a melamine-based resin, a urea-based resin, a furan resin, and the like.

In the present invention, the resin preferably includes one or more selected from the group consisting of a polyvinylacetal-based resin, a resole-type phenol-based resin, an acrylic resin, a polyester-based resin, a phenoxy resin, a polyimide-based resin, and a xylene-based resin. Among these, a polyvinyl acetal-based resin is suitably used from the viewpoint of the film formation state, connection reliability, adhesion to a substrate, and the like.

(Coupling agent)

An epoxy resin composition of the present invention may contain a coupling agent. Consequently, the short-time heat bonding strength of the epoxy resin composition can be improved. Examples of the coupling agent include a silane coupling agent, a titanium coupling agent, an aluminum coupling agent, and a zirconium coupling agent. Examples of the silane coupling agent include amino group-containing silane compounds, such as aminoethyl aminopropyl trimethoxysilane, aminoethyl aminopropyl methyldimethoxysilane, and aminoethyl aminopropyl methylmethoxysilane; vinyl group-containing silane compounds, such as vinyltrimethoxysilane; epoxy group-containing silane compounds, such as γ-glycidoxypropyltrimethoxysilane; (meth)acryloyl group-containing silane compounds, such as γ-methacryloxypropyl trimethoxysilane; mercaptosilanes, such as γ-mercaptopropyltrimethoxysilane; and isocyanate group-containing silane compound, such as γ-isocyanate propyl trimethoxysilane. Examples of the titanium coupling agent include tetraisopropyl titanate, tetra-n-butyl titanate, butyl titanate, tetraoctyl titanate, titanium acetylacetonate, titanium tetraacetylacetonate, titanium ethyl acetoacetate, a titanium dodecyl benzene sulfonate compound, titanium octylene glycolate, titanium ethyl acetoacetate, a titanium lactate ammonium salt, titanium lactate, titanium triethanolaminate, tetraisopropyl titanate, tetra-t-butyl titanate, tetrastearyl titanate, titanium acetylacetonate, titanium octylene glycolate, titanium isostearate, titanium diethanolaminate, titanium aminoethylaminoethanolate, and a titanium oligomer. Examples of the aluminum coupling agent include an aluminate compound having an alkoxide group, such as alkyl acetoacetate aluminum diisopropylate; and an aluminate compound having an acetylacetonate group, such as aluminum trisacetylacetonate. Examples of the zirconium coupling agent include tetra-n-propoxy zirconium, tetra-butoxy zirconium, zirconium tetraacetylacetonate, zirconium dibutoxy bis(acetylacetonate), zirconium tributoxy ethyl acetoacetate, zirconium butoxy acetyl acetonate bis(ethyl acetoacetate), and zirconium tetrakis(2,4-pentanedionate).

The coupling agents may be used alone or in a combination of two or more.

<Properties of conductive resin composition>

The conductive resin composition of the present invention can be in any form, such as a powder, solid, paste, or liquid (varnish) form. In the use as a conductive material, a conductive adhesive, or a circuit connection material, a paste or liquid (varnish) form at room temperature (25°C) is suitable.

<Properties of conductive resin composition>

The conductive resin composition of the present invention is excellent in conductivity. For example, a conductive film obtained by casting or applying the conductive resin composition onto a peelable substrate and subjected to drying and then peeling preferably has a volume resistivity of less than $3.0 \times 10^{-4}$ Ω·cm. More preferably, the volume resistivity of the conductive film is less than $2.0 \times 10^{-4}$ Ω·cm. Here, the volume resistivity is obtained by the method described in Examples.

The conductive resin composition of the present invention is excellent in the adhesion to various substrates, for example, the adhesion to glass, a metal, or plastics (e.g. polyester).

In both cases of storage by leaving to stand at room temperature (25°C) for 24 hours (room temperature (25°C) storage for 24 hours) and storage by leaving to stand in a refrigerator (4°C) for 1 week (refrigeration (4°C) storage for 1 week), solidification, surface skinning, and liquid separation do not occur, and the increase in the viscosity after room temperature storage for 24 hours and refrigeration storage for 1 week is little, and the conductive resin composition of the present invention is thus excellent in storage stability.

<Method for preparing conductive resin composition>

In preparation of the conductive resin composition of the present invention, a tin powder, a specific epoxy resin, and a specific dicarboxylic acid compound as essential components and, as needed, a thiol-based compound, a solvent, and other components are added to a mixing container in an arbitrary order and mixed to manufacture the composition. In the mixing, for example, a method of mixing with a rotating and revolving mixer, a ball mill, a roll mill, a bead mill, a planetary mixer, a tumbler, a stirrer, an agitator, a mechanical homogenizer, an ultrasonic homogenizer, a high-pressure homogenizer, a paint shaker, a V-type blender, a Nauta mixer, a Banbury mixer, a kneading roll, a single- or twin-screw extruder, or the like is appropriately used.

The temperature when preparing the conductive resin composition (the temperature when mixing each component) is not particularly limited. The conductive resin composition can be prepared under heating or the like, as needed, for example, at 10°C to 100°C.

The atmosphere when preparing the conductive resin composition is not particularly limited. The preparation can be performed in air or in an inert atmosphere.

<Purpose of conductive resin composition>

The purpose of the conductive resin composition of the present invention is a use in the manufacture of a conductive object. The conductive object may include another member in addition to the conductive resin composition.

The conductive object is, for example, one or more selected from the group consisting of a conductive material, a circuit connection material, a conductive paste, a film having conductivity, a conductive fiber, a conductive coating material, a conductive material for semiconductor packaging, a conductive material for microelectronic devices, an anti-static material, an electromagnetic shielding material, a conductive adhesive (such as a die attachment adhesive), a die attach paste, an actuator, a sensor, and a conductive resin molded product.

For example, a conductive material, a circuit connection material, a conductive paste, a conductive coating material, a conductive adhesive, and the like can be constituted by using a solvent as a component of the conductive resin composition. The viscosity at this time is not limited and can be adjusted depending on the purpose and the like from a varnish state with a low viscosity to a paste state with a high viscosity.

For example, the conductive resin composition containing a solvent and the like as needed can be formed into a film having a conductivity by applying the composition to various types of substrates by a casting method, a dipping method, a bar coating method, a dispenser method, a roll coating method, a gravure coating method, screen printing, a flexographic printing method, a spray coating method, a spin coating method, an inkjet method, or the like and heating and drying it at a temperature of 300°C or less. The atmosphere for the drying is, for example, one or more selected from the group consisting of in air, in an inert gas, in vacuum, a reduced pressure, and the like. In particular, from the viewpoint of suppressing the deterioration of the film having a conductivity (e.g., antioxidation of the tin powder and the like), an atmosphere of an inert gas, such as nitrogen and argon, is preferable.

The conductive resin composition of the present invention can be molded by a molding method, such as extrusion

molding, injection molding, and compression molding, and can be used as a molded product. Examples of the molded product include an electronic equipment part, an automotive part, a mechanical machinery part, a food container, a film, a sheet, and a fiber.

[Conductive film]

The conductive film of the present invention can be formed from the above-described conductive resin composition. The conductive film of the present invention preferably has a volume resistivity of less than $3.0 \times 10^{-4}$ $\Omega \cdot cm$. The volume resistivity of the conductive film is more preferably less than $2.0 \times 10^{-4}$ $\Omega \cdot cm$ and further preferably less than $1.0 \times 10^{-4}$ $\Omega \cdot cm$. The conductive film of the present invention can have a volume resistivity of less than $1.0 \times 10^{-4}$ $\Omega \cdot cm$ (an order of $10^{-5}$ $\Omega \cdot cm$), which is equivalent to that of the conductive film formed from a silver paste.

Here, the volume resistivity is obtained by the method described in Examples.

The method for forming a conductive film from the conductive resin composition is not particularly limited. For example, a conductive film can be formed by applying or printing the conductive resin composition added with a solvent onto an arbitrary substrate and drying it. Alternatively, the conductive film can be obtained by casting or applying the conductive resin composition on a peelable substrate and dying and then pealing it.

The conditions for forming the conductive film are not particularly limited and can be appropriately set depending on the object to be coated and the like. The temperature for drying and the like after the application of the conductive resin composition is, for example, 50°C or more, preferably 90°C or more and is, for example, 250°C or less, preferably 220°C or less. The time for drying and the like is, for example, 5 minutes or more, preferably 7 minutes or more and is, for example, 300 minutes or less, preferably 200 minutes or less.

In the present invention, a conductive film can be formed by adjusting the wet film thickness and/or the dry film thickness at the time of forming the conductive film depending on the purpose, the application and printing method, and the like.

The wet film thickness of the conductive film (the thickness of wet film of the conductive resin composition) is not particularly limited and can be appropriately adjusted depending on the purpose and the like. Examples include 5 μm or more and preferably 10 μm or more, and examples include 1000 μm or less and preferably 500 μm or less.

The dry film thickness of the conductive film is not particularly limited and can be appropriately adjusted depending on the purpose and the like. The thickness is, for example, 1 μm or more and preferably 5 μm or more and is, for example, 1000 μm or less and preferably 500 μm or less.

[Conductive material]

The conductive material of the present invention includes the conductive resin composition. The conductive material can be obtained by, for example, dissolving and/or dispersing the conductive resin composition in the above solvent as needed.

The conductive material may further include, in addition to a tin powder, a specific epoxy resin, and a specific dicarboxylic acid compound, various additives for forming a conductive material (for example, a conductive powder other than the tin powder, various types of curing agents, a surfactant, a pH-adjusting agent (such as an amine-based compound), an adhesion promoter, a viscoelasticity-adjusting agent, a wetting and dispersing agent, a leveling agent, a pigment, a UV absorbent, an antioxidant, and a flame retardant).

The conductive material is obtained in a varnish state or a paste state by placing the above components in a mixing container and then mixing them using one or more mixers selected from the group consisting of a rotating and revolving mixer, a ball mill, a roll mill, a bead mill, a planetary mixer, a tumbler, a stirrer, an agitator, a mechanical homogenizer, an ultrasonic homogenizer, a high-pressure homogenizer, a paint shaker, and the like.

The conductive material can be used as, for example, a printing conductive ink for wiring formation, a circuit-forming material, or a material for forming an internal or external electrode of a passive component.

When the conductive material is used as a printing conductive ink, the printing method is, for example, one or more selected from the group consisting of screen printing, metal mask printing, inkjet printing, flexographic printing, gravure printing, a dispenser method, and the like. In the present invention, it is preferable to use one or more printing methods selected from the group consisting of screening printing, inkjet printing, and the like, because they are excellent in printability and shape retention property.

Here, the mesh in the screen printing method can be appropriately selected, and it is preferable to adopt a mesh that merely does not excessively remove the conductive powder and lead-free solder powder in the conductive material.

The application method for applying the conductive material to an article or the like is not particularly limited. An arbitrary application method can be adopted depending on the shape, use mode, and the like of the article or the like. The application method is, for example, one or more selected from the group consisting of spin coating, dip coating, immersion, die coating, air spray, airless spray, electrostatic application, brush coating, roller coating, roll coating, curtain flow coating,

roller curtain coating, die coating, inkjetting, dispenser application, and the like.

The thickness of the coating film formed by applying the conductive material is not particularly limited and can be appropriately adjusted depending on various types of purposes. Examples include 1 μm or more, preferably 2 μm or more, and more preferably 5 μm or more and is 400 μm or less, preferably 200 μm or less, and more preferably 100 μm or less.

The conductive material is excellent in one or more properties selected from the group consisting of adhesion to various types of substrates, leveling (surface smoothness), printability, and the like, in addition to storage stability and conductivity under refrigeration and at room temperature.

[Conductive adhesive]

The conductive adhesive of the present invention includes the conductive resin composition and can be obtained by, for example, dissolving and/or dispersing the conductive resin composition in the solvent as needed.

The conductive adhesive is used to bond parts to each other so as to have conductivity. For example, the conductive adhesive is used for adhesion or the like that requires conductivity in manufacturing of a battery or electrical and electric equipment. The conductive adhesive may further include as needed one or more selected from the group consisting of a solvent, a curing agents for curing the epoxy resin, an adhesion imparting agent, a viscoelasticity-adjusting agent, a wetting and dispersing agent, a curing accelerator (curing catalyst), a reactive diluent, a conductive powder other than the tin powder, a resin other than the epoxy resin, an antioxidant, a pigment, a filler, an anticorrosive agent, a defoaming agent, a coupling agent, anti-settling agents, a leveling agent, a heavy metal inactivator, a surfactant, a pH-adjusting agent, a UV absorbent, a flame retardant, an adhesion imparting agent, and the like.

The conductive adhesive is obtained in a varnish state or a paste state by placing the above components in a mixing container and then mixing them using at least one mixer selected from the group consisting of a rotating and revolving mixer, a ball mill, a roll mill, a bead mill, a planetary mixer, a tumbler, a stirrer, an agitator, a mechanical homogenizer, an ultrasonic homogenizer, a high-pressure homogenizer, a paint shaker, a V-type blender, a Nauta mixer, a Banbury mixer, a kneading roll, a single-screw extruder, a twin-screw extruder, and the like.

The conductive adhesive of the present invention can be used as an anisotropic conductive adhesive. Consequently, highly reliable conductive connection can be formed in electronic components such as a miniaturized IC chip and a light-emitting diode, electrode connection of a circuit board, and the like.

Examples of the adhesion structure in which bonded components are bonded to each other via the conductive adhesive of the present invention include RFID-related products, such as an IC card and an IC tag, in which an IC chip is attached to a substrate having an electrode and light-emitting electronic components in which a light-emitting diode is attached to a substrate having an electrode. For example, an adhesion structure using a conductive adhesive can be formed by forming a large number of electrodes on at least one surface of a substrate, applying the conductive adhesive of the present invention so as to at least cover each of the electrodes to form an adhesive film, placing each of the electrode portions and the electrode portion of each of the corresponding electronic components so as to face each other and pressure-bonding them, and curing the adhesive layer.

The means for applying the conductive adhesive of the present invention to a substrate is not particularly limited. Examples of the means include a method of applying the conductive resin composition to a substrate. In the present invention, the application can be performed by printing, discharging, and the like. The printing method is, for example, preferably one or more selected from the group consisting of screen printing, metal mask printing, inkjet printing, flexographic printing, gravure printing, a dispenser method, and the like, and it is preferable to use one or more printing methods selected from the group consisting of screen printing, inkjet printing, and the like, because they are excellent in printability and shape retention property.

Here, the mesh in screen printing can be appropriately selected, and it is preferable to use a mesh that merely does not excessively remove the conductive powder in the conductive adhesive.

The thickness of the adhesive film formed by application of the conductive adhesive can be an appropriate thickness depending on the various purposes. Examples include 1 μm or more, preferably 2 μm or more, and more preferably 5 μm or more and is 200 μm or less.

The conductive adhesive of the present invention may be formed into a film form and used. The conductive adhesive in a film form can be obtained by, for example, a method of applying a conductive adhesive solution, which is obtained by adding a solvent or the like to the conductive adhesive composition as needed, onto a peelable support and removing the solvent or the like. The conductive adhesive in a film form is more convenient in terms of handling and the like. One or more layers of the conductive adhesive in a film form can also be used as a multilayer structure as needed together with one or more insulating adhesive layers, one or more peelable material layers, or the like.

The conductive adhesive of the present invention can usually bond adherends together by applying heat and pressure in combination. The heating temperature is not particularly limited within a range not impairing the adherends and is, for example, 70°C or more and 250°C or less. The pressure is not particularly limited within a range not impairing the adherend and is, for example, 0.1 MPa or more and 10 MPa or less. Heat and pressure are preferably applied for, for

example, 0.5 seconds or more and 120 seconds or less.

The conductive adhesive of the present invention is used for electrically connecting adherends together. For example, the conductive adhesive can be used as an adhesive for different types of adherends, i.e., for bonding and also electrically connecting adherends that are made of different materials from each other and have different thermal expansion coefficients. Furthermore, the conductive adhesive of the present invention can be used as an anisotropic conductive adhesive, a conductive paste, a circuit connection material such as a conductive adhesive film, an underfill material, and a semiconductor element-bonding material such as LOC tape.

[Circuit connection material]

The circuit connection material of the present invention includes the conductive resin composition. It is used for conductive connection between various types of electronic components and a circuit board and connection (adhesion) between electrical and electronic circuits.

The shape or the like of the circuit connection material is not particularly limited, but is preferably a liquid or film form.

The circuit connection material in a liquid form can be obtained by, for example, mixing a solvent, such as an organic solvent, with the conductive resin composition of the present invention for liquefaction.

The circuit connection material in a film form can be obtained by, for example, by casting or applying the above liquefied conductive resin composition of the present invention directly onto a peelable substrate to form a coat, dying the coat by removing the solvent to form a film, and then peeling the film from the peelable substrate.

In addition, the circuit connection material in a film form can be obtained by, for example, immersing non-woven fabric or the like in the above liquefied conductive resin composition of the present invention, then forming it on a peelable substrate, dying by removing the solvent, and then peeling from the peelable substrate.

The electrical connection method and the like using the circuit connection material are not particularly limited. An example thereof is a method in which a circuit connection material is disposed between the electrode of an electronic component, a circuit, or the like and the electrode on a substrate facing it and is heated to electrically connect both electrodes and to bond between both electrodes. During the heating, a pressure may be applied as needed.

The method for disposing a circuit connection material between electrodes facing each other is not particularly limited. Examples thereof include a method of applying a circuit connection material in a liquid form and a method of putting a circuit connection material in a film form between electrodes.

In addition, the examples include a method for conductive connection between a pin of an electronic component or the like and a circuit by providing a circuit connection material at the base of the pin and performing butt connection to constitute a conductive connection.

The circuit connection material can be used as a substantial anisotropic conductive material and can be used in an electrode connection method by forming a circuit connection material having excellent adhesion between electrodes on substrates facing each other and achieving contact between the electrodes and adhesion between the substrates by applying heat and pressure. As the substrate for forming the electrode, an inorganic substance such as a semiconductor, glass, and ceramic, an organic substance such as a polyimide-based resin and a polycarbonate-based resin, and each combination thereof such as glass/epoxy can be used.

Note that when a solder powder that melts at low temperature is included as a component of the circuit connection material, conductive connection at low temperature of 250°C or less, for example, 200°C or less is possible.

## Examples

The present invention will now be described in more detail with reference to Examples. Note that the present invention is not limited to these Examples. "Part(s)" means "part(s) by mass" unless otherwise noted.

[Component used]

The components used in Examples are as follows:

- Tin powder 1: spherical tin powder (D50 = 5.5 μm, Sn ≥ 99.5 mass%)
- Epoxy resin 1: solid bisphenol A-type epoxy resin (manufactured by NIPPON STEEL Chemical & Material Co., Ltd., "YD-014"; epoxy equivalent: 900 to 1000 g/eq; softening point: 100°C)
- Epoxy resin 2: solid bisphenol A-type epoxy resin (manufactured by NIPPON STEEL Chemical & Material Co., Ltd., "YD-011"; epoxy equivalent: 440 to 510 g/eq; softening point: 66°C)
- Epoxy resin 3: solid bisphenol A-type epoxy resin (manufactured by NIPPON STEEL Chemical & Material Co., Ltd., "YD-019"; epoxy equivalent: 2200 to 2900 g/eq; softening point: 138°C)

- Epoxy resin 4: solid epoxy resin (manufactured by Nippon Kayaku Co., Ltd., "LCE-2615"; epoxy equivalent: 494 g/eq; softening point: 93°C)
- Epoxy resin 5: solid bisphenol F-type epoxy resin (manufactured by NIPPON STEEL Chemical & Material Co., Ltd., "YDF-2004"; epoxy equivalent: 850 to 1050 g/eq; softening point: 85°C)
- Epoxy resin 6: solid bisphenol F-type epoxy resin (manufactured by Mitsubishi Chemical Corporation, "jER-4005P"; epoxy equivalent: 950 to 1200 g/eq; softening point: 87°C)
- Epoxy resin 7: semisolid rubber-modified epoxy resin (manufactured by DIC Corporation, "TSR-601"; epoxy equivalent: 450 to 500 g/eq)
- Epoxy resin 8: solid dicyclopentadiene-type epoxy resin (manufactured by DIC Corporation, "HP-7200"; epoxy equivalent: 254 to 264 g/eq; softening point: 57 to 68°C)
- Epoxy resin 9: solid phenol novolac-type epoxy resin (manufactured by DIC Corporation, "N-770"; epoxy equivalent: 183 to 193 g/eq; softening point: 65 to 75°C)
- Epoxy resin 10: solid biphenyl aralkyl-type epoxy resin (manufactured by Nippon Kayaku Co., Ltd., "NC-3000"; epoxy equivalent: 276 g/eq; softening point: 57°C)
- Epoxy resin 11: solid naphthol-cresol novolac-type epoxy resin (manufactured by Nippon Kayaku Co., Ltd., "NC-7000L"; epoxy equivalent: 232 g/eq; softening point: 90°C)
- Epoxy resin 12: liquid bisphenol A-type epoxy resin (manufactured by ADEKA Corporation, "EP-4100G"; epoxy equivalent: 190 g/eq; softening point: less than 25°C)
- Epoxy resin 13: liquid propylene oxide-added bisphenol A-type epoxy resin (manufactured by ADEKA Corporation, "EP-4000S"; epoxy equivalent: 260 g/eq softening point: less than 25°C)
- Epoxy resin 14: liquid phenol novolac-type epoxy resin (manufactured by Nippon Kayaku Co., Ltd., "RE-305S"; epoxy equivalent: 173 g/eq; softening point: less than 25°C)
- Straight-chain dicarboxylic acid compound 1: adipic acid ($HOOC-(CH_2)_4-COOH$)
- Straight-chain dicarboxylic acid compound 2: pimelic acid ($HOOC-(CH_2)_5-COOH$)
- Straight-chain dicarboxylic acid compound 3: sebacic acid ($HOOC-(CH_2)_8-COOH$)
- Straight-chain dicarboxylic acid compound 4: succinic acid ($HOOC-(CH_2)_2-COOH$)
- Straight-chain dicarboxylic acid compound 5: glutaric acid ($HOOC-(CH_2)_3-COOH$)
- Straight-chain dicarboxylic acid compound 6: diglycolic acid ($HOOC-CH_2-O-CH_2-COOH$)
- Branched-chain dicarboxylic acid compound 1: long-chain branched dibasic acid (manufactured by Okamura Oil Mill, Ltd., "MMA-10R")
- Branched-chain dicarboxylic acid compound 2: long-chain branched dibasic acid (manufactured by Okamura Oil Mill, Ltd., "SB-12")
- Thiol-based compound 1: thiocyanuric acid (1,3,5-triazine-2,4,6-trithiol)
- Solvent 1: diethylene glycol monobutyl ether (butyl carbitol)
- Solvent 2: diethylene glycol dibutyl ether (dibutyl carbitol)

<Conductivity evaluation>

Regarding conductive films (dry coating films) formed from conductive resin compositions, the volume resistivity was determined by the following method, and the conductivity evaluation was performed by the method shown below.

(Production of conductive film for measurement (dry coating film))

A conductive resin composition was hand-printed using a metal mask with a pattern of 2 cm × 2 cm and a thickness of 100 μm to produce a coating film of 2 cm × 2 cm on a glass substrate of 5 cm × 5 cm. Subsequently, the coating film was thermally cured under heat treatment conditions of 160°C for 60 minutes to produce each conductive film (dry coating film) for measuring the volume resistivity.

(Volume resistivity)

The volume resistivity of the obtained conductive film (dry coating film) was measured with a resistivity meter "Loresta GP-MCP T610" (manufactured by Nittoseiko Analytech Co., Ltd.) by a 4-terminal method in 2 directions (two directions of a direction passing through the center of the coating film and parallel to the upper side of the coating film and a direction perpendicular to the direction), and the average volume resistivity thereof was calculated. Furthermore, two conductive films (dry coating films) were produced from each of the conductive resin compositions, and the average volume resistivity of the two conductive films (dry coating films) was calculated as a volume resistivity. The calculated volume resistivities are collectively shown in Table 1 to Table 6. A volume resistivity that was too high to measure (unmeasurable volume resistivity) is indicated by "UM" in Table 1 to Table 6, and a conductive resin composition having low

coating performance not to be uniformly applied (poor application) is indicated by "UC" in Table 1 to Table 6.

(Conductivity evaluation)

The volume resistivity and was evaluated by the following criteria. In this evaluation, A is a pass, and D is a fail:

A: a volume resistivity of less than $3.0 \times 10^{-4}$ ($\Omega$·cm).
D: a volume resistivity of $3.0 \times 10^{-4}$ ($\Omega$·cm) or more or an unmeasurable volume resistivity (UM) or poor application (UC).

The viscosity measurement and storage stability evaluation of a conductive resin composition were performed by the following methods:

<Viscosity measurement>

The viscosity of each conductive resin composition was measured using a rheometer (manufactured by TA Instruments, Rheometer DHR-2). The measurement was started using a 20 mm cone-plate at 25°C and a shear rate of 10 $s^{-1}$, and the viscosity was recorded 180 seconds after the start of measurement.

<Storage stability>

The produced conductive resin compositions were placed in respective containers and stored by leaving to stand at room temperature (25°C) for 24 hours (room temperature (25°C) storage for 24 hours) and stored by leaving to stand in a refrigerator (4°C) for 1 week (refrigeration (4°C) storage for 1 week), and then the storage stability of each conductive resin composition was evaluated by the following evaluation item and criteria. Furthermore, based on the respective evaluations, the room temperature (25°C) storage for 24 hours and the refrigeration (4°C) storage for 1 week were totally evaluated by the following criteria. In this evaluation, A is a pass, and D is a fail. The evaluation results are collectively shown in Table 1 to Table 6:

A: all four evaluations of solidification, surface skinning, liquid separation, and thickening rate were passed.
D: one or more of four evaluations of solidification, surface skinning, liquid separation, and thickening rate were failed.

(Solidification)

After the storage under the prescribed conditions, each conductive resin composition was touched with a spatula. A conductive resin composition that could be scooped with the spatula was not solidified and rated as A, and a conductive resin composition that did not have fluidity and could not be scooped with the spatula was solidified and rated as D. In this evaluation, A is a pass, and D is a fail. Note that when the volume resistivity was "UC (poor application)", solidification was not verified, and an oblique line was drawn in the table.

(Surface skinning)

After the storage under the prescribed conditions, the appearance of each conductive resin composition was verified. When no surface skinning was present on the surface of the conductive resin composition, the conductive resin composition was rated as A, and when the surface skinning was present, the conductive resin composition was rated as D. Here, the "surface skinning" is a state in which a coating film is formed on the surface portion of the conductive resin composition in contact with air. In the evaluation, A is a pass, and D is a fail. Note that when the volume resistivity was "UC (poor application)" and when solidification was observed, surface skinning was not verified, and an oblique line was drawn in the table.

(Liquid separation)

After the storage under the prescribed conditions, the appearance of each conductive resin composition was verified. When the liquid did not separate and did not float on the surface of the conductive resin composition, the conductive resin composition was rated as A, and when the liquid separated and floated, the conductive resin composition was rated as D. In this evaluation, A is a pass, D is a fail. Note that, when the volume resistivity was "UC (poor application)" and when solidification or surface skinning was observed, liquid separation was not verified, and an oblique line was drawn in the table.

(Viscosity)

After the storage under the prescribed conditions, the viscosity of each conductive resin composition was measured using a rheometer (manufactured by TA Instruments, Rheometer DHR-2). The measurement was started using a 20 mm cone-plate at 25°C and a shear rate of 10 $s^{-1}$, and the viscosity at 180 seconds after the start of measurement was defined as the viscosity value. Note that, when solidification, surface skinning, or liquid separation occurred after storage and thereby the viscosity could not be measured (unmeasurable viscosity), and "UM" was drawn in Table 1 to Table 6. When the volume resistivity was "UC (poor application)", the viscosity was not measured, and an oblique line was drawn in the table.

(Thickening rate)

After the storage under the prescribed conditions, the value obtained by measuring the viscosity of each conductive resin composition was compared to the value obtained by measuring the viscosity immediately after the production of the conductive resin composition to calculate the thickening rate, which was evaluated by the following criteria. In this evaluation, A and B are passes, and D is a fail.

Thickening rate [%] = {(viscosity after storage under prescribed conditions/viscosity immediately after production) - 1} × 100,

A: a thickening rate of less than 50%;
B: a thickening rate of 50% or more and less than 100%; and
D: a thickening rate of 100% or more or unmeasurable viscosity.

[Example 1]

Tin powder 1 (15.00 parts), epoxy resin 1 (0.84 parts), straight-chain dicarboxylic acid compound 1 (0.40 parts), and solvent 1 (1.00 parts) were mixed by stirring with a rotating and revolving mixer (manufactured by Thinky Corporation, "Thinky Mixer (Awatorirentaro) AR-100") to obtain a conductive resin composition. In the obtained conductive resin composition, the amount of the tin powder (the tin powder amount in all amount of non-solvent components) in the total amount of the components other the solvent (in Example 1, the total amount of the tin powder 1, the epoxy resin 1, and the straight-chain dicarboxylic acid compound 1) was 92.36 mass%.
The obtained conductive resin composition was measured for the viscosity.
A conductive film (dry coating film) was produced from the obtained conductive resin composition, and the volume resistivity was measured and evaluated.
The obtained conductive resin composition was evaluated for the storage stability (room temperature (25°C) storage for 24 hours and refrigeration (4°C) storage for 1 week).
These results are collectively shown in Table 1.

[Examples 2 to 32 and Comparative Examples 1 to 13]

Conductive resin compositions were produced as in Example 1 except that the constitutional components of the conductive resin compositions and the contents (parts) thereof were changed to those shown in Table 1 to Table 6.
The obtained conductive resin compositions were each measured for the viscosity.
A conductive film (dry coating film) was produced from each of the obtained conductive resin compositions, and volume resistivity thereof was measured and evaluated.
The obtained conductive resin compositions were each evaluated for the storage stability (room temperature (25°C) storage for 24 hours and refrigeration (4°C) storage for 1 week).
These results are collectively shown in Table 1 to Table 6.

[Table 1]

| | | Example 1 | Example 2 | Example 3 | Example 4 | Example 5 | Example 6 | Example 7 | Example 8 |
|---|---|---|---|---|---|---|---|---|---|
| Tin powder 1 | | 15.00 | 15.00 | 15.00 | 15.00 | 15.00 | 15.00 | 15.00 | 15.00 |
| Epoxy resin 1 | | 0.84 | 1.00 | 0.84 | 0.84 | 0.84 | 0.84 | 0.84 | 0.84 |
| Straight-chain dicarboxylic acid compound 1 | | 0.40 | 0.24 | 0.20 | 0.40 | 0.20 | | | |
| Straight-chain dicarboxylic acid compound 2 | | | | | | | 0.40 | 0.40 | 0.20 |
| Straight-chain dicarboxylic acid compound 3 | | | | | | | | | |
| Straight-chain dicarboxylic acid compound 4 | | | | | | | | | |
| Straight-chain dicarboxylic acid compound 5 | | | | | | | | | |
| Straight-chain dicarboxylic acid compound 6 | | | | | | | | | |
| Branched-chain dicarboxylic acid compound 1 | | | | | | 0.20 | | | 0.20 |
| Branched-chain dicarboxylic acid compound 2 | | | | | | | | | |
| Thiol-based compound 1 | | | | | 0.02 | 0.02 | | | 0.02 |
| Solvent 1 | | 1.00 | 1.00 | 1.00 | 1.00 | 0.75 | 0.75 | 1.00 | 0.75 |
| Solvent 2 | | | | | | | | | |
| Total | | 17.24 | 17.24 | 17.04 | 17.26 | 17.01 | 16.99 | 17.24 | 17.01 |
| Tin powder amount in all amount of non-solvent components (mass%) | | 92.36 | 92.36 | 93.52 | 92.25 | 92.25 | 92.36 | 92.36 | 92.25 |
| Volume resistivity (Ω·cm) | | $4.1\times10^{-5}$ | $7.3\times10^{-5}$ | $1.4\times10^{-4}$ | $5.6\times10^{-5}$ | $6.9\times10^{-5}$ | $5.9\times10^{-5}$ | $7.1\times10^{-5}$ | $1.5\times10^{-4}$ |
| Conductivity evaluation | | A | A | A | A | A | A | A | A |
| Viscosity (Pa·s) immediately after production | | 143.9 | 110.0 | 82.4 | 123.3 | 320.5 | 291.6 | 67.9 | 240.2 |
| Storage stability | Solidification | A | A | A | A | A | A | A | A |
| | Surface skinning | A | A | A | A | A | A | A | A |
| | Liquid separation | A | A | A | A | A | A | A | A |
| Storage under refrigeration (4°C) for 1 week | Viscosity (Pa·s) | 140.9 | 114.2 | 88.4 | 122.9 | 329.0 | 291.8 | 74.0 | 227.0 |
| | Thickening rate (%) | -2% | 4% | 7% | 0% | 3% | 0% | 9% | -5% |
| | Thickening rate evaluation | A | A | A | A | A | A | A | A |

(continued)

| | | | | | | | | | |
|---|---|---|---|---|---|---|---|---|---|
| | Total evaluation | A | A | A | A | A | A | A | A |
| Storage stability | Solidification | A | A | A | A | A | A | A | A |
| | Surface skinning | A | A | A | A | A | A | A | A |
| | Liquid separation | A | A | A | A | A | A | A | A |
| Storage at room temperature (25°C) for 24 hours | Viscosity (Pa·s) | 130.1 | 113.6 | 86.5 | 124.7 | 359.0 | 283.1 | 60.7 | 245.0 |
| | Thickening rate (%) | -10% | 3% | 5% | 1% | 12% | -3% | -11% | 2% |
| | Thickening rate evaluation | A | A | A | A | A | A | A | A |
| | Total evaluation | A | A | A | A | A | A | A | A |

[Table 2]

| | Example 9 | Example 10 | Example 11 | Example 12 | Example 13 | Example 14 | Example 15 | Example 16 |
|---|---|---|---|---|---|---|---|---|
| Tin powder 1 | 15.00 | 15.00 | 15.00 | 15.00 | 15.00 | 15.00 | 15.00 | 15.00 |
| Epoxy resin 1 | 0.84 | 0.84 | 0.84 | 0.84 | 0.84 | 0.84 | 1.04 | 1.04 |
| Straight-chain dicarboxylic acid compound 1 | | | | | | | | |
| Straight-chain dicarboxylic acid compound 2 | 0.20 | 0.20 | 0.20 | 0.20 | 0.20 | | | |
| Straight-chain dicarboxylic acid compound 3 | | | | | | | | |
| Straight-chain dicarboxylic acid compound 4 | | | | | | 0.40 | | |
| Straight-chain dicarboxylic acid compound 5 | | | | | | | 0.20 | |
| Straight-chain dicarboxylic acid compound 6 | | | | | | | | 0.20 |
| Branched-chain dicarboxylic acid compound 1 | 0.20 | 0.20 | 0.20 | 0.20 | 0.20 | | | |
| Branched-chain dicarboxylic acid compound 2 | | | | | | | | |
| Thiol-based compound 1 | 0.04 | 0.06 | 0.02 | 0.04 | 0.06 | | | |
| Solvent 1 | 0.75 | 0.75 | 1.00 | 1.00 | 1.00 | 1.00 | 1.00 | 1.00 |
| Solvent 2 | | | | | | | | |
| Total | 17.03 | 17.05 | 17.26 | 17.28 | 17.30 | 17.24 | 17.24 | 17.24 |
| Tin powder amount in all amount of non-solvent components (mass%) | 92.14 | 92.02 | 92.25 | 92.14 | 92.02 | 92.36 | 92.36 | 92.36 |
| Volume resistivity (Ω·cm) | $8.5\times10^{-5}$ | $1.2\times10^{-4}$ | $1.1\times10^{-4}$ | $1.3\times10^{-4}$ | $2.4\times10^{-4}$ | $1.5\times10^{-4}$ | $1.7\times10^{-4}$ | $5.2\times10^{-5}$ |
| Conductivity evaluation | A | A | A | A | A | A | A | A |
| Viscosity (Pa·s) immediately after production | 285.0 | 260.6 | 65.6 | 68.9 | 75.6 | 150.5 | 95.3 | 228.3 |

(continued)

| | Example | Example | Example | Example | Example | Example | Example | Example | |
|---|---|---|---|---|---|---|---|---|---|
| | 9 | 10 | 11 | 12 | 13 | 14 | 15 | 16 | |
| Storage stability | Solidification | A | A | A | A | A | A | A | A |
| | Surface skinning | A | A | A | A | A | A | A | A |
| | Liquid separation | A | A | A | A | A | A | A | A |
| Storage under refrigeration (4°C) for 1 week | Viscosity (Pa·s) | 302.5 | 318.9 | 74.5 | 82.7 | 100.3 | 150.3 | 120.9 | 205.0 |
| | Thickening rate (%) | 6% | 22% | 14% | 20% | 33% | 0% | 27% | -10% |
| | Thickening rate evaluation | A | A | A | A | A | A | A | A |
| | Total evaluation | A | A | A | A | A | A | A | A |
| Storage stability | Solidification | A | A | A | A | A | A | A | A |
| | Surface skinning | A | A | A | A | A | A | A | A |
| | Liquid separation | A | A | A | A | A | A | A | A |
| Storage at room temperature (25°C) for 24 hours | Viscosity (Pa·s) | 252.9 | 267.0 | 66.2 | 70.0 | 76.0 | 136.5 | 112.9 | 200.0 |
| | Thickening rate (%) | -11% | 2% | 1% | 2% | 1% | -9% | 18% | -12% |
| | Thickening rate evaluation | A | A | A | A | A | A | A | A |
| | Total evaluation | A | A | A | A | A | A | A | A |

[Table 3]

| | Example 17 | Example 18 | Example 19 | Example 20 | Example 21 | Example 22 | Example 23 | Example 24 | |
|---|---|---|---|---|---|---|---|---|---|
| Tin powder 1 | 15.00 | 15.00 | 15.00 | 15.00 | 15.00 | 15.00 | 15.00 | 15.00 | |
| Epoxy resin 1 | 1.04 | 0.94 | 1.14 | 0.84 | 0.84 | 0.84 | 0.84 | 0.84 | |
| Straight-chain dicarboxylic acid compound 1 | 0.10 | 0.10 | 0.16 | | | 0.10 | 0.04 | 0.20 | |
| Straight-chain dicarboxylic acid compound 2 | | | | | | | | | |
| Straight-chain dicarboxylic acid compound 3 | | | | | 0.30 | 0.36 | 0.30 | 0.36 | |
| Straight-chain dicarboxylic acid compound 4 | | | | | | | | | |
| Straight-chain dicarboxylic acid compound 5 | | | | | 0.10 | 0.04 | | | |
| Straight-chain dicarboxylic acid compound 6 | | 0.10 | 0.10 | | | | | | |
| Branched-chain dicarboxylic acid compound 1 | | | | | | | | | |
| Branched-chain dicarboxylic acid compound 2 | | | 0.10 | | | | | | 0.20 |
| Thiol-based compound 1 | | | | | | | | | |
| Solvent 1 | | 1.00 | 1.00 | 1.00 | 1.00 | 1.00 | 1.00 | 1.00 | 1.00 |
| Solvent 2 | | | | | | | | | |
| Total | | 17.24 | 17.24 | 17.30 | 17.24 | 17.24 | 17.24 | 17.24 | 17.24 |
| Tin powder amount in all amount of non-solvent components (mass%) | | 92.36 | 92.36 | 92.02 | 92.36 | 92.36 | 92.36 | 92.36 | 92.36 |
| Volume resistivity (Ω·cm) | | $8.1\times10^{-5}$ | $7.2\times10^{-5}$ | $9.9\times10^{-5}$ | $3.4\times10^{-5}$ | $9.2\times10^{-5}$ | $2.7\times10^{-4}$ | $2.7\times10^{-4}$ | $7.7\times10^{-5}$ |
| Conductivity evaluation | | A | A | A | A | A | A | A | A |
| Viscosity (Pa·s) immediately after production | | 147.4 | 108.6 | 138.9 | 130.0 | 149.0 | 113.1 | 124.0 | 66.2 |
| Storage stability | Solidification | A | A | A | A | A | A | A | A |
| | Surface skinning | A | A | A | A | A | A | A | A |
| | Liquid separation | A | A | A | A | A | A | A | A |

(continued)

| | | | | | | | | | |
|---|---|---|---|---|---|---|---|---|---|
| | Example | Example | Example | Example | Example | Example | Example | Example | |
| | 17 | 18 | 19 | 20 | 21 | 22 | 23 | 24 | |
| Storage under refrigeration (4°C) for 1 week | Viscosity (Pa·s) | 168.6 | 129.7 | 169.6 | 154.2 | 151.6 | 109.5 | 107.2 | 64.2 |
| | Thickening rate (%) | 14% | 19% | 22% | 19% | 2% | -3% | -14% | -3% |
| | Thickening rate evaluation | A | A | A | A | A | A | A | A |
| | Total evaluation | A | A | A | A | A | A | A | A |
| Storage stability | Solidification | A | A | A | A | A | A | A | A |
| | Surface skinning | A | A | A | A | A | A | A | A |
| Storage at room temperature | Liquid separation | A | A | A | A | A | A | A | A |
| | Viscosity (Pa·s) | 157.8 | 118.1 | 148.4 | 145.5 | 131.4 | 122.6 | 125.0 | 61.4 |
| | Thickening rate (%) | 7% | 9% | 7% | 12% | -12% | 8% | 1% | -7% |
| (25°C) for 24 hours | Thickening rate evaluation | A | A | A | A | A | A | A | A |
| | Total evaluation | A | A | A | A | A | A | A | A |

[Table 4]

| | Example | Example | Comparative Example | Comparative Example | Comparative Example | Comparative Example | Comparative Example | Comparative Example |
|---|---|---|---|---|---|---|---|---|
| | 25 | 26 | 1 | 2 | 3 | 4 | 5 | 6 |
| Tin powder 1 | 15.00 | 15.00 | 15.00 | 15.00 | 15.00 | 15.00 | 15.00 | 15.00 |
| Epoxy resin 1 | 0.84 | 0.84 | 0.84 | 0.84 | 0.84 | 0.84 | 0.84 | 1.24 |
| Straight-chain dicarboxylic acid compound 1 | | | | | | | | |
| Straight-chain dicarboxylic acid compound 2 | | | | | | | | |
| Straight-chain dicarboxylic acid compound 3 | | | 0.40 | 0.40 | 0.20 | | | |
| Straight-chain dicarboxylic acid compound 4 | | | | | | | | |
| Straight-chain dicarboxylic acid compound 5 | | | | | | | | |
| Straight-chain dicarboxylic acid compound 6 | 0.20 | 0.40 | | | | | | |
| Branched-chain dicarboxylic acid compound 1 | | | | | 0.20 | 0.40 | | |
| Branched-chain dicarboxylic acid compound 2 | 0.20 | | | | | | 0.40 | |
| Thiol-based compound 1 | | | | | 0.02 | | | |
| Solvent 1 | 1.00 | | 1.00 | 0.75 | 1.00 | 1.00 | 1.00 | 1.00 |
| Solvent 2 | | 1.00 | | | | | | |
| Total | 17.24 | 17.24 | 17.24 | 16.99 | 17.26 | 17.24 | 17.24 | 17.24 |
| Tin powder amount in all amount of non-solvent components (mass%) | 92.36 | 92.36 | 92.36 | 92.36 | 92.25 | 92.36 | 92.36 | 92.36 |
| Volume resistivity (Ω·cm) | $3.0\times10^{-5}$ | $3.2\times10^{-5}$ | $4.5\times10^{-4}$ | UC | $7.8\times10^{-4}$ | $2.9\times10^{+1}$ | $3.5\times10^{+0}$ | UM |
| Conductivity evaluation | A | A | D | D | D | D | D | D |

(continued)

| | | Example | Example | Comparative Example | Comparative Example | Comparative Example | Comparative Example | Comparative Example | Comparative Example |
|---|---|---|---|---|---|---|---|---|---|
| | | 25 | 26 | 1 | 2 | 3 | 4 | 5 | 6 |
| Viscosity (Pa·s) immediately after production | | 106.2 | 130.7 | 143.1 | | 91.5 | 72.9 | 35.7 | 149.8 |
| Storage stability | Solidification | A | A | A | | A | A | A | A |
| | Surface skinning | A | A | A | | A | A | A | A |
| | Liquid separation | A | A | A | | A | A | A | A |
| Storage under refrigeration (4°C) for 1 week | Viscosity (Pa·s) | 110. 9 | 138.0 | 114.2 | | 92.5 | 80.2 | 41.8 | 176.0 |
| | Thickening rate (%) | 4% | 6% | -20% | | 1% | 10% | 17% | 17% |
| | Thickening rate evaluation | A | A | A | | A | A | A | A |
| | Total evaluation | A | A | A | | A | A | A | A |
| Storage stability | Solidification | A | A | A | | A | A | A | A |
| | Surface skinning | A | A | A | | A | A | A | A |
| | Liquid separation | A | A | A | | A | A | A | A |

(continued)

| | | | | | | | | | |
|---|---|---|---|---|---|---|---|---|---|
| | Example | | Example | Comparative Example | Comparative Example | Comparative Example | Comparative Example | Comparative Example | Comparative Example |
| | 25 | | 26 | 1 | 2 | 3 | 4 | 5 | 6 |
| Storage at room temperature (25°C) for 24 hours | Viscosity (Pa·s) | 109. 4 | 121.1 | 112.6 | | 93.7 | 78.9 | 39.4 | 160.0 |
| | Thickening rate (%) | 3% | -7% | -21% | | 2% | 8% | 10% | 7% |
| | Thickening rate evaluation | A | A | A | | A | A | A | A |
| | Total evaluation | A | A | A | | A | A | A | A |

[Table 5]

| | | Example 1 | Example 27 | Example 28 | Example 29 | Example 30 | Example 31 | Example 32 |
|---|---|---|---|---|---|---|---|---|
| Tin powder 1 | | 15.00 | 15.00 | 15.00 | 15.00 | 15.00 | 15.00 | 15.00 |
| Epoxy resin 1 | | 0.84 | | | | | | |
| Epoxy resin 2 | | | 0.84 | | | | | |
| Epoxy resin 3 | | | | 0.84 | | | | |
| Epoxy resin 4 | | | | | 0.84 | | | |
| Epoxy resin 5 | | | | | | 0.84 | | |
| Epoxy resin 6 | | | | | | | 0.84 | |
| Epoxy resin 7 | | | | | | | | 0.84 |
| Epoxy resin 8 | | | | | | | | |
| Epoxy resin 9 | | | | | | | | |
| Epoxy resin 10 | | | | | | | | |
| Epoxy resin 11 | | | | | | | | |
| Epoxy resin 12 | | | | | | | | |
| Epoxy resin 13 | | | | | | | | |
| Epoxy resin 14 | | | | | | | | |
| Straight-chain dicarboxylic acid compound 1 | | 0.40 | 0.40 | 0.40 | 0.40 | 0.40 | 0.40 | 0.40 |
| Solvent 1 | | 1.00 | 0.85 | 1.25 | 0.90 | 1.00 | 1.00 | 0.75 |
| Total | | 17.24 | 17.09 | 17.49 | 17.14 | 17.24 | 17.24 | 16.99 |
| Tin powder amount in all amount of non-solvent components (mass%) | | 92.36 | 92.36 | 92.36 | 92.36 | 92.36 | 92.36 | 92.36 |
| Volume resistivity (Ω·cm) | | $4.1\times10^{-5}$ | $5.0\times10^{-5}$ | $3.6\times10^{-5}$ | $4.3\times10^{-5}$ | $3.8\times10^{-5}$ | $3.8\times10^{-5}$ | $7.4\times10^{-5}$ |
| Conductivity evaluation | | A | A | A | A | A | A | A |
| Viscosity (Pa·s) immediately after production | | 143.9 | 67.7 | 215.6 | 165.6 | 110.1 | 148.0 | 163.1 |
| Storage stability | Solidification | A | A | A | A | A | A | A |
| | Surface skinning | A | A | A | A | A | A | A |
| | Liquid separation | A | A | A | A | A | A | A |
| Storage under refrigeration (4°C) for 1 week | Viscosity (Pa·s) | 140.9 | 80.5 | 213.0 | 153.1 | 102.7 | 148.3 | 179.0 |
| | Thickening rate (%) | -2% | 19% | -1% | -8% | -7% | 0% | 10% |
| | Thickening rate evaluation | A | A | A | A | A | A | A |
| | Total evaluation | A | A | A | A | A | A | A |

(continued)

| | | Example 1 | Example 27 | Example 28 | Example 29 | Example 30 | Example 31 | Example 32 |
|---|---|---|---|---|---|---|---|---|
| Storage stability | Solidification | A | A | A | A | A | A | A |
| | Surface skinning | A | A | A | A | A | A | A |
| | Liquid separation | A | A | A | A | A | A | A |
| Storage at room temperature | Viscosity (Pa·s) | 130.1 | 72.5 | 206.2 | 146.0 | 105.6 | 124.1 | 182.2 |
| | Thickening rate (%) | -10% | 7% | -4% | -12% | -4% | -16% | 12% |
| | Thickening rate evaluation | A | A | A | A | A | A | A |
| (25°C) for 24 hours | Total evaluation | A | A | A | A | A | A | A |

[Table 6]

| | Comparativ e Example | Comparativ e Example | Comparativ e Example | Comparativ e Example | Comparativ e Example | Comparativ e Example | Comparativ e Example |
|---|---|---|---|---|---|---|---|
| | 7 | 8 | 9 | 10 | 11 | 12 | 13 |
| Tin powder 1 | 15.00 | 15.00 | 15.00 | 15.00 | 15.00 | 15.00 | 15.00 |
| Epoxy resin 1 | | | | | | | |
| Epoxy resin 2 | | | | | | | |
| Epoxy resin 3 | | | | | | | |
| Epoxy resin 4 | | | | | | | |
| Epoxy resin 5 | | | | | | | |
| Epoxy resin 6 | | | | | | | |
| Epoxy resin 7 | | | | | | | |
| Epoxy resin 8 | 0.84 | | | | | | |
| Epoxy resin 9 | | 0.84 | | | | | |
| Epoxy resin 10 | | | 0.84 | | | | |
| Epoxy resin 11 | | | | 0.84 | | | |
| Epoxy resin 12 | | | | | 0.84 | | |
| Epoxy resin 13 | | | | | | 0.84 | |
| Epoxy resin 14 | | | | | | | 0.84 |
| Straight-chain dicarboxylic acid compound 1 | 0.40 | 0.40 | 0.40 | 0.40 | 0.40 | 0.40 | 0.40 |
| Solvent 1 | 1.00 | 1.00 | 1.00 | 1.00 | 1.00 | 1.00 | 1.00 |
| Total | 17.24 | 17.24 | 17.24 | 17.24 | 17.24 | 17.24 | 17.24 |
| Tin powder amount in all amount of non-solvent components (mass%) | 92.36 | 92.36 | 92.36 | 92.36 | 92.36 | 92.36 | 92.36 |
| **Volume** resistivity (Ω·cm) | UM | UC | UC | UM | UM | $5.4\times10^{-4}$ | $2.6\times10^{-3}$ |
| Conductivity evaluation | D | D | D | D | D | D | D |
| Viscosity (Pa·s) immediately after production | 35.9 | | | 34.2 | 12.7 | 12.2 | 22.3 |

(continued)

| | | Comparativ e Example | Comparativ e Example | Comparativ e Example | Comparativ e Example | Comparativ e Example | Comparativ e Example | Comparativ e Example |
|---|---|---|---|---|---|---|---|---|
| | | 7 | 8 | 9 | 10 | 11 | 12 | 13 |
| Storage stability Storage under re-frigeratio n (4°C) for 1 week | Solidificatio n | A | | | A | A | A | A |
| | Surface skinning | A | | | A | A | A | A |
| | Liquid separation | D | | | D | D | D | D |
| | Viscosity (Pa·s) | UM | | | UM | UM | UM | UM |
| | Thickening rate (%) | - | | | - | - | - | - |
| | Thickening rate evaluation | D | | | D | D | D | D |
| | Total evaluation | D | | | D | D | D | D |
| Storage stability Storage at room temperatur e (25°C) for 24 hours | Solidificatio n | A | | | A | A | A | A |
| | Surface skinning | A | | | A | A | A | A |
| | Liquid separation | D | | | D | D | D | D |
| | Viscosity (Pa·s) | UM | | | UM | UM | UM | UM |
| | Thickening rate (%) | - | | | - | - | - | - |
| | Thickening rate evaluation | D | | | D | D | D | D |
| | Total evaluation | D | | | D | D | D | D |

The conductive films formed from the conductive resin compositions according to Examples 1 to 32 all had a volume resistivity of less than $3.0 \times 10^{-4}$ Ω·cm, and in some cases, the conductive resin compositions had a volume resistivity of less than $1.0 \times 10^{-4}$ Ω·cm and exhibited excellent conductivity that is equal to or higher than that of a silver paste,. Consequently, it is demonstrated that a conductive resin composition that is less expensive than a silver paste or the like and exhibits a high conductivity equal to that of a silver paste was formed.

In addition, it was demonstrated that the conductive resin compositions according to Examples 1 to 32 were excellent in storage stability because solidification, surface skinning, and liquid separation did not occur in both the room temperature (25°C) storage for 24 hours and the refrigeration (4°C) storage for 1 week, and the increase in the viscosity after room temperature storage for 24 hours and refrigeration storage for 1 week was little.

## Claims

1. A conductive resin composition comprising:

   a tin powder (a);
   an epoxy resin (b); and
   a dicarboxylic acid compound (c),
   wherein the epoxy resin (b) includes an epoxy resin that has an epoxy equivalent of 400 g/eq or more and is in a solid or semisolid state at 25°C, and
   the dicarboxylic acid compound (c) includes a dicarboxylic acid compound that has 4 or more and 9 or less carbon atoms.

2. The conductive resin composition according to Claim 1, wherein a content of the tin powder (a) is 92.01 mass% or more and 99.50 mass% or less based on 100 mass% of the total amount of components other than the solvent in the conductive resin composition.

3. The conductive resin composition according to Claim 1 or 2, wherein the dicarboxylic acid compound (c) further includes a dicarboxylic acid compound having 10 or more carbon atoms.

4. The conductive resin composition according to Claim 1 or 2, further comprising a thiol-based compound (d).

5. A conductive film formed from the conductive resin composition according to Claim 1 or 2 and having a volume resistivity of less than $4.0 \times 10^{-4}$ Ω·cm.

6. A conductive material comprising the conductive resin composition according to Claim 1 or 2.

7. A conductive adhesive comprising the conductive resin composition according to Claim 1 or 2.

8. A circuit connection material comprising the conductive resin composition according to Claim 1 or 2.

## INTERNATIONAL SEARCH REPORT

International application No.
**PCT/JP2024/010273**

### A. CLASSIFICATION OF SUBJECT MATTER

***C08L 63/00***(2006.01)i; ***C08G 59/42***(2006.01)i; ***C08K 3/08***(2006.01)i; ***C08K 5/092***(2006.01)i; ***C09J 9/02***(2006.01)i; ***C09J 11/04***(2006.01)i; ***C09J 11/06***(2006.01)i; ***C09J 163/00***(2006.01)i; ***H01B 1/22***(2006.01)i; ***H05K 3/12***(2006.01)i
FI: C08L63/00 C; C08G59/42; C08K3/08; C08K5/092; C09J9/02; C09J11/04; C09J11/06; C09J163/00; H01B1/22 A; H01B1/22 D; H05K3/12 610B

According to International Patent Classification (IPC) or to both national classification and IPC

### B. FIELDS SEARCHED

Minimum documentation searched (classification system followed by classification symbols)

C08L63/00; C08G59/42; C08K3/08; C08K5/092; C09J9/02; C09J11/04; C09J11/06; C09J163/00; H01B1/22; H05K3/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2016-032022 A (THE YOKOHAMA RUBBER CO., LTD.) 07 March 2016 (2016-03-07) claim 1, paragraphs [0054], [0067], examples 1-5 | 1-8 |
| Y | JP 2016-100134 A (NORITAKE CO., LIMITED) 30 May 2016 (2016-05-30) claim 1, paragraphs [0023], [0046], examples 15-16 | 1-8 |
| Y | WO 2022/234732 A1 (SAKATA INX CORP.) 10 November 2022 (2022-11-10) claims 1-6, paragraphs [0006], [0013], [0021], [0039], [0042], examples 1-20 | 1-8 |
| Y | JP 2019-156964 A (PANASONIC INTELLECTUAL PROPERTY MANAGEMENT CO., LTD.) 19 September 2019 (2019-09-19) claim 1, paragraph [0014], examples 1-15 | 4 |
| Y | JP 10-298526 A (HITACHI CHEMICAL CO., LTD.) 10 November 1998 (1998-11-10) claim 1, paragraph [0003], examples 1-2 | 4 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 April 2024** | **23 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (July 2022)

INTERNATIONAL SEARCH REPORT

International application No.
PCT/JP2024/010273

C. DOCUMENTS CONSIDERED TO BE RELEVANT

| Category* | Citation of document, with indication, where appropriate, of the relevant passages | Relevant to claim No. |
|---|---|---|
| Y | JP 2000-230112 A (AJINOMOTO CO., INC.) 22 August 2000 (2000-08-22) claim 1, paragraph [0005], examples 1-3 | 4 |

Form PCT/ISA/210 (second sheet) (July 2022)

**INTERNATIONAL SEARCH REPORT**
**Information on patent family members**

International application No.
**PCT/JP2024/010273**

| Patent document cited in search report | Publication date (day/month/year) | Patent family member(s) | Publication date (day/month/year) |
|---|---|---|---|
| JP 2016-032022 A | 07 March 2016 | (Family: none) | |
| JP 2016-100134 A | 30 May 2016 | CN 105609162 A | |
| | | TW 201619266 A | |
| WO 2022/234732 A1 | 10 November 2022 | CN 117321145 A | |
| | | KR 10-2024-0004508 A | |
| JP 2019-156964 A | 19 September 2019 | US 2019/0284388 A1<br>claim 1, paragraph [0017], examples 1-15 | |
| | | CN 110272704 A | |
| JP 10-298526 A | 10 November 1998 | (Family: none) | |
| JP 2000-230112 A | 22 August 2000 | EP 1291390 A1<br>claim 1, paragraph [0006], examples 1-3 | |
| | | WO 2001/092416 A1 | |
| | | TW 538091 B | |
| | | CN 1454238 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020205245 A
- JP 2022172874 A
- JP 6428716 B
- JP 2000309773 A
- WO 2015019666 A